# EUROPEAN PATENT APPLICATION

(11) **EP 4 496 452 A1**
(43) Date of publication of application: **22.01.2025**
(21) Application number: 23770432.5
(22) Date of filing: 02.03.2023
(51) Int. Cl.: H10K 50/858, G09F 9/30, H10K 50/844, H10K 50/852, H10K 59/121, H10K 59/38

(54) **LIGHT-EMITTING DEVICE AND ELECTRONIC APPARATUS**

(30) Priority: 16.03.2022 JP 2022041609
(71) Applicant: Sony Semiconductor Solutions Corporation, Atsugi-shi, Kanagawa 243-0014 (JP)
(72) Inventor: SAWABE, Tomoaki, Atsugi-shi, Kanagawa 243-0014 (JP); SHIMATSU, Tomohiko, Atsugi-shi, Kanagawa 243-0014 (JP); UCHIDA, Yoshinori, Atsugi-shi, Kanagawa 243-0014 (JP); TATEJIMA, Kota, Atsugi-shi, Kanagawa 243-0014 (JP); YOSHIDA, Jun, Atsugi-shi, Kanagawa 243-0014 (JP)
(74) Representative: D Young & Co LLP
(86) International application number: PCT/JP2023/007800
(87) International publication number: WO 2023/176474

(57) **Abstract**

Provided is a light emitting device (10) including a plurality of light emitting elements (100) arranged on a substrate. Each of the light emitting elements includes: a first electrode (202) disposed on the substrate; a pixel separation film (208) covering a peripheral portion of the first electrode; a light emitting layer (204) that is laminated on the first electrode and emits light; a second electrode (206) that is laminated on the light emitting layer and transmits light from the light emitting layer; and a protective film (210) that is laminated on the second electrode and transmits light from the light emitting layer. The protective films of the adjacent light emitting elements are disposed so as to be continuous. A surface of the protective film located on a side opposite to the second electrode has a plurality of protrusions (212) and recesses (214).

## Description

### Field

The present disclosure relates to a light emitting device and an electronic apparatus.

### Background

In recent years, a display device (light emitting device) using an organic electroluminescence (EL) element as a light emitting element has been developed. The display device includes a plurality of pixels each including, for example, a lower electrode, a light emitting layer laminated on the lower electrode, and an upper electrode laminated on the light emitting layer. In addition, when a predetermined voltage is supplied to the lower electrode and the upper electrode, the light emitting layer interposed between the lower electrode and the upper electrode emits light.

### Citation List

### Patent Literature

Patent Literature 1: JP 2019-102462 A
Patent Literature 2: JP 2018-92873 A

### Summary

### Technical Problem

However, in such a display device (light emitting device) including a plurality of pixels as described above, a deeper study has not been made on improvement of light extraction efficiency from the pixels.

Therefore, the present disclosure proposes a light emitting device and an electronic apparatus capable of improving light extraction efficiency.

### Solution to Problem

According to the present disclosure, there is provided a light emitting device including a plurality of light emitting elements arranged on a substrate. In the light emitting device, each of the light emitting elements includes: a first electrode disposed on the substrate; a pixel separation film covering a peripheral portion of the first electrode; a light emitting layer that is laminated on the first electrode and emits light; a second electrode that is laminated on the light emitting layer and transmits light from the light emitting layer; and a protective film that is laminated on the second electrode and transmits light from the light emitting layer, the protective films of the adjacent light emitting elements are formed so as to be continuous, a surface of the protective film located on a side opposite to the second electrode has a plurality of protrusions and recesses, at least one of the plurality of protrusions is formed above the light emitting element, and a part of the recess adjacent to the protrusion formed above the light emitting element overlaps with the peripheral portion of the first electrode covered with the pixel separation film when viewed from above the substrate.

Furthermore, according to the present disclosure, there is provided an electronic apparatus including a light emitting device. The light emitting device includes a plurality of light emitting elements arranged on a substrate. In the light emitting device, each of the light emitting elements includes: a first electrode disposed on the substrate; a pixel separation film covering a peripheral portion of the first electrode; a light emitting layer that is laminated on the first electrode and emits light; a second electrode that is laminated on the light emitting layer and transmits light from the light emitting layer; and a protective film that is laminated on the second electrode and transmits light from the light emitting layer, the protective films of the adjacent light emitting elements are formed so as to be continuous, a surface of the protective film located on a side opposite to the second electrode has a plurality of protrusions and recesses, at least one of the plurality of protrusions is formed above the light emitting element, and a part of the recess adjacent to the protrusion formed above the light emitting element overlaps with the peripheral portion of the first electrode covered with the pixel separation film when viewed from above the substrate.

### Brief Description of Drawings

FIG. 1 is a schematic diagram illustrating an example of an overall configuration of a light emitting device 10 according to an embodiment of the present disclosure.
FIG. 2 is a schematic circuit diagram for explaining a connection relationship in a subpixel 100 in an m-th row and an n-th column.
FIG. 3 is a cross-sectional view for explaining an example of a configuration of a subpixel 100a according to Comparative Example.
FIG. 4 is a cross-sectional view for explaining an example of a cross-sectional configuration of a subpixel 100 according to a first embodiment of the present disclosure.
FIG. 5 is a cross-sectional view for explaining an example of a planar configuration of the subpixel 100 according to the first embodiment of the present disclosure.
FIG. 6 is a cross-sectional view for explaining an example of a cross-sectional configuration of a subpixel 100 according to Modification 1 of the first embodiment of the present disclosure.
FIG. 7 is a cross-sectional view for explaining an example of a planar configuration of a subpixel 100 according to Modification 2 of the first embodiment of the present disclosure.
FIG. 8 is a cross-sectional view for explaining an example of a cross-sectional configuration of a subpixel 100 according to Modification 3 of the first embodiment of the present disclosure.
FIG. 9 is a cross-sectional view for explaining a method for manufacturing the subpixel 100 according to the first embodiment of the present disclosure.
FIG. 10 is a cross-sectional view for explaining an example of a cross-sectional configuration of a subpixel 100 according to a second embodiment of the present disclosure.
FIG. 11 is a cross-sectional view for explaining a method for manufacturing the subpixel 100 according to the second embodiment of the present disclosure.
FIG. 12 is a cross-sectional view for explaining an example of a cross-sectional configuration of a subpixel 100 according to Modification of the second embodiment of the present disclosure.
FIG. 13 is a cross-sectional view for explaining a method for manufacturing the subpixel 100 according to Modification of the second embodiment of the present disclosure.
FIG. 14 is a cross-sectional view for explaining an example of a planar configuration of a subpixel 100 according to a third embodiment of the present disclosure.
FIG. 15A is a cross-sectional view (part 1) for explaining an example of a cross-sectional configuration of the subpixel 100 according to the third embodiment of the present disclosure.
FIG. 15B is a cross-sectional view (part 2) for explaining an example of the cross-sectional configuration of the subpixel 100 according to the third embodiment of the present disclosure.
FIG. 16 is a cross-sectional view for explaining a method for manufacturing the subpixel 100 according to the third embodiment of the present disclosure.
FIG. 17 is a cross-sectional view for explaining an example of a planar configuration of a subpixel 100 according to Modification of the third embodiment of the present disclosure.
FIG. 18 is a cross-sectional view for explaining an example of a cross-sectional configuration of the subpixel 100 according to Modification of the third embodiment of the present disclosure.
FIG. 19 is a cross-sectional view for explaining an example of a cross-sectional configuration of a subpixel 100 according to a fourth embodiment of the present disclosure.
FIG. 20 is a cross-sectional view for explaining an example of a cross-sectional configuration of a subpixel 100 according to Modification 1 of the fourth embodiment of the present disclosure.
FIG. 21 is a cross-sectional view for explaining an example of a cross-sectional configuration of a subpixel 100 according to Modification 2 of the fourth embodiment of the present disclosure.
FIG. 22 is a cross-sectional view for explaining an example of a cross-sectional configuration of a subpixel 100 according to Modification 3 of the fourth embodiment of the present disclosure.
FIG. 23 is a cross-sectional view for explaining an example of a cross-sectional configuration of a subpixel 100 according to Modification 4 of the fourth embodiment of the present disclosure.
FIG. 24 is a cross-sectional view for explaining an example of a planar configuration of a subpixel 100 according to a fifth embodiment of the present disclosure.
FIG. 25A is a cross-sectional view (part 1) for explaining an example of a cross-sectional configuration of the subpixel 100 according to the fifth embodiment of the present disclosure.
FIG. 25B is a cross-sectional view (part 2) for explaining an example of the cross-sectional configuration of the subpixel 100 according to the fifth embodiment of the present disclosure.
FIG. 26 is an explanatory diagram for explaining the fifth embodiment of the present disclosure.
FIG. 27 is a cross-sectional view for explaining an example of a cross-sectional configuration of a subpixel 100 according to Modification 1 of the fifth embodiment of the present disclosure.
FIG. 28 is a cross-sectional view for explaining an example of a cross-sectional configuration of a subpixel 100 according to Modification 2 of the fifth embodiment of the present disclosure.
FIG. 29 is an explanatory diagram for explaining Modification 3 of the fifth embodiment of the present disclosure.
FIG. 30A is a conceptual diagram (part 1) for explaining a relationship among a normal line LN passing through a center of a light emitting unit, a normal line LN' passing through a center of a lens member, and a normal line LN" passing through a center of a wavelength selection unit.
FIG. 30B is a conceptual diagram (part 2) for explaining the relationship among the normal line LN passing through the center of the light emitting unit, the normal line LN' passing through the center of the lens member, and the normal line LN" passing through the center of the wavelength selection unit.
FIG. 30C is a conceptual diagram (part 3) for explaining the relationship among the normal line LN passing through the center of the light emitting unit, the normal line LN' passing through the center of the lens member, and the normal line LN" passing through the center of the wavelength selection unit.
FIG. 30D is a conceptual diagram (part 4) for explaining the relationship among the normal line LN passing through the center of the light emitting unit, the normal line LN' passing through the center of the lens member, and the normal line LN" passing through the center of the wavelength selection unit.
FIG. 30E is a conceptual diagram (part 5) for explaining a relationship among a normal line LN passing through a center of a light emitting unit, a normal line LN' passing through a center of a lens member, and a normal line LN" passing through a center of a wavelength selection unit.
FIG. 30F is a conceptual diagram (part 6) for explaining the relationship among the normal line LN passing through the center of the light emitting unit, the normal line LN' passing through the center of the lens member, and the normal line LN" passing through the center of the wavelength selection unit.
FIG. 30G is a conceptual diagram (part 7) for explaining the relationship among the normal line LN passing through the center of the light emitting unit, the normal line LN' passing through the center of the lens member, and the normal line LN" passing through the center of the wavelength selection unit.
FIG. 31 is a schematic cross-sectional view for explaining a first example of a resonator structure.
FIG. 32 is a schematic cross-sectional view for explaining a second example of the resonator structure.
FIG. 33 is a schematic cross-sectional view for explaining a third example of the resonator structure.
FIG. 34 is a schematic cross-sectional view for explaining a fourth example of the resonator structure.
FIG. 35 is a schematic cross-sectional view for explaining a fifth example of the resonator structure.
FIG. 36 is a schematic cross-sectional view for explaining a sixth example of the resonator structure.
FIG. 37 is a schematic cross-sectional view for explaining a seventh example of the resonator structure.
FIG. 38A is a front view illustrating an example of an external appearance of a digital still camera.
FIG. 38B is a rear view illustrating an example of the external appearance of the digital still camera.
FIG. 39 is an external view of a head mounted display.
FIG. 40 is an external view of a see-through head mounted display.
FIG. 41 is an external view of a television device.
FIG. 42 is an external view of a smartphone.
FIG. 43A is a view (part 1) illustrating an internal configuration of an automobile.
FIG. 43B is a view (part 2) illustrating the internal configuration of the automobile.

### Description of Embodiments

Hereinafter, a preferred embodiment of the present disclosure will be described in detail with reference to the attached drawings. Note that, in the present specification and the drawings, components having substantially the same functional configuration are denoted by the same reference sign, and redundant description is omitted. In addition, in the present specification and the drawings, a plurality of components having substantially the same or similar functional configuration may be distinguished from each other by attaching different alphabets after the same reference sign. Note that, in a case where it is not particularly necessary to distinguish a plurality of components having substantially the same or similar functional configuration from each other, only the same reference sign is attached.

Numerical values and shapes expressed in the following description mean not only mathematically or geometrically defined numerical values or shapes but also numerical values or similar shapes including an allowable difference (error/distortion) in an operation of a light emitting device and a process for manufacturing the light emitting device. Furthermore, "identical" used for a specific numerical value or shape in the following description does not mean only a case of complete mathematical or geometric coincidence, but also a case of having an allowable difference (error/distortion) in an operation of a light emitting device and a process for manufacturing the light emitting device.

Furthermore, in the following description, "electrically connecting" means connecting a plurality of elements to each other directly or indirectly via another element.

Note that the description will be given in the following order.
1. Overall configuration of light emitting device according to embodiment of present disclosure
2. Background leading to creation of embodiment of present disclosure
3. First embodiment
   3.1 Detailed configuration
   3.2 Modification
   3.3 Manufacturing method
4. Second embodiment
   4.1 Detailed configuration
   4.2 Manufacturing method
   4.3 Modification
5. Third embodiment
   5.1 Detailed configuration
   5.2 Manufacturing method
   5.3 Modification
6. Fourth embodiment
   6.1 Detailed configuration
   6.2 Modification
7. Fifth embodiment
   7.1 Detailed configuration
   7.2 Modification
8. Summary
9. Modification
   9.1 Modification 1
   9.2 Modification 2
10. Application Example
11. Supplement

### <<1. Overall configuration of light emitting device according to embodiment of present disclosure>>

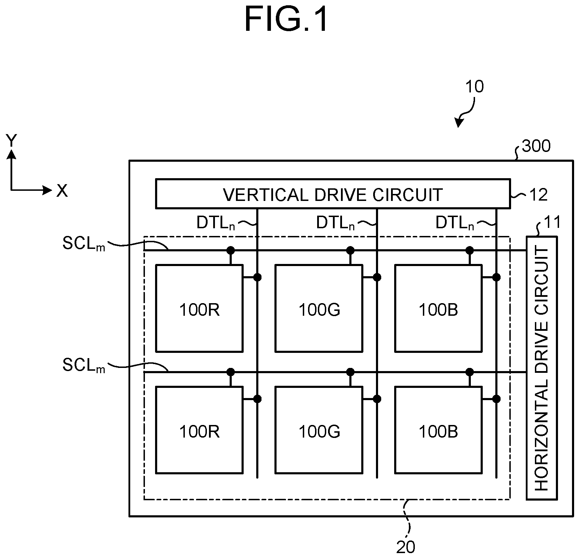

An example of an overall configuration of an organic electroluminescence (EL) light emitting device 10 (hereinafter, simply referred to as "light emitting device 10") according to an embodiment of the present disclosure used as a display device or a lighting device will be described with reference to FIG. 1. FIG. 1 is a schematic diagram illustrating an example of an overall configuration of the light emitting device 10 according to the embodiment of the present disclosure.

The light emitting device 10 is, for example, a device in which light emitting elements such as an organic light emitting diode (OLED) or a micro-OLED are formed in an array. Such a light emitting device 10 can be applied to, as a display device, for example, a display device for virtual reality (VR), mixed reality (MR), or augmented reality (AR), an electronic view finder (EVF), or a small projector.

The light emitting device 10 has a display region and a peripheral region formed on a peripheral edge of the display region. As illustrated in FIG. 1, a plurality of subpixels 100R, 100G, and 100B are arranged in a matrix in the display region of the light emitting device 10. The subpixel 100R can emit red light, the subpixel 100G can emit green light, and the subpixel 100B can emit blue light. Note that, in the following description, the subpixels 100R, 100G, and 100B are referred to as subpixels 100 in a case where these are not particularly distinguished from each other.

Furthermore, in the present embodiment, one pixel 20 is constituted by combining three types of subpixels 100R, 100G, and 100B that emit different types of light. Note that, in the present embodiment, the number and arrangement of the subpixels 100R, the number and arrangement of the subpixels 100G, and the number and arrangement of the subpixels 100B, the subpixels 100R, 100G, and 100B being three types of subpixels included in one pixel 20, are not particularly limited. Furthermore, in the present embodiment, the light emitting device 10 includes a plurality of pixels 20 arranged in a matrix on a substrate.

In addition, as illustrated in FIG. 1, a horizontal drive circuit 11 and a vertical drive circuit 12 are disposed in the peripheral region of the light emitting device 10.

The horizontal drive circuit 112 can scan the subpixels 100 in a row unit (In FIG. 1, a direction extending in the X direction is referred to as a row direction.) when a signal is written in the subpixels 100, and can sequentially supply a scanning signal to each scanning line SCLm. The horizontal drive circuit 11 can be constituted by, for example, a shift register that sequentially shifts (transfers) a start pulse in synchronization with an input clock pulse.

The vertical drive circuit 12 can supply a signal voltage of a signal corresponding to luminance information supplied from a signal supply source (not illustrated) to subpixels 100 selected in a column unit (In FIG. 1, a direction extending in the Y direction is referred to as a column direction.) via a signal line DTLn.

Note that, in the embodiment of the present disclosure, the configuration of the light emitting device 10 is not limited to the configuration illustrated in FIG. 1. That is, the configuration illustrated in FIG. 1 is merely an example, and the light emitting device 10 according to the embodiment of the present disclosure can have various configurations.

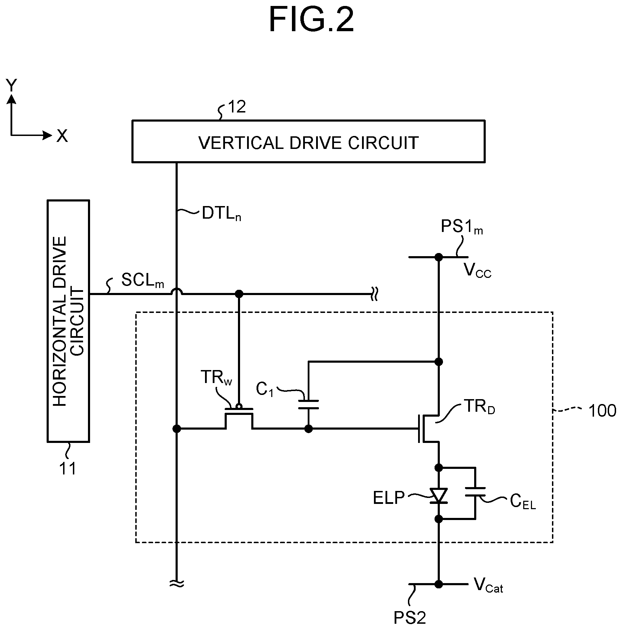

Next, a circuit configuration of a subpixel 100 in an m-th row and an n-th column will be described with reference to FIG. 2. FIG. 2 is a schematic circuit diagram for explaining a connection relationship in the subpixel 100 in the m-th row and the n-th column.

In the light emitting device 10, as described above, the subpixels 100 each including a light emitting element ELP are arranged in a two-dimensional matrix in a state of being connected to the scanning line SCLm extending in the row direction (X direction in FIG. 1) and the signal line DTLn extending in the column direction (Y direction in FIG. 1).

Furthermore, as illustrated in FIG. 2, the light emitting device 10 includes a feeder line PS1m that supplies a drive voltage to the subpixels 100, and a common feeder line PS2 that is commonly connected to all the subpixels 100. In addition, a predetermined drive voltage Vcc or the like is supplied from a power supply unit (not illustrated) to the feeder line PS1m, and a common voltage Vcat (for example, ground potential) is supplied to the common feeder line PS2.

Here, it is assumed that the number of scanning lines SCL and the number of feeder lines PS1 are each M. The subpixels 100 in the m-th row (where m = 1, 2 ..., P) are connected to the m-th scanning line SCLm and the m-th feeder line PS1m, and form one display element row. Note that, in FIG. 2, only the scanning line SCLm and the feeder line PS1m are illustrated. In addition, it is assumed that the number of signal lines DTL is N. The subpixels 100 in the n-th column (where n = 1, 2 ..., N) are connected to the n-th signal line DTLn. Note that, in FIG. 2, only the signal line DTLn is illustrated. Hereinafter, the subpixel 100 located in the m-th row and the n-th column may be referred to as an (n, m)-th subpixel 100.

In addition, as described above, the light emitting device 10 is sequentially scanned in a row unit by a scanning signal from the horizontal drive circuit 11. Specifically, in the light emitting device 10, the M subpixels 100 arranged in the m-th row are simultaneously driven. In other words, in the M subpixels 100 arranged in the row direction, a light emitting/non-light emitting timing is controlled in the row unit to which the M subpixels 100 belong. For example, in a case where a display frame rate of the light emitting device 10 is FR (times/second), a scanning period per row (so-called horizontal scanning period) when the light emitting device 10 is sequentially scanned in a row unit is less than (1/FR) × (1/P) seconds.

As illustrated in FIG. 2, the subpixel 100 includes a light emitting element ELP and a drive circuit that drives the light emitting element ELP. The light emitting element ELP is constituted by an organic electroluminescence light emitting element. The drive circuit includes a write transistor TRw, a drive transistor TR_{D}, and a capacitor C1. When a current flows through the light emitting element ELP via the drive transistor TR_{D}, the light emitting element ELP can emit light. Each of the transistors is constituted by, for example, a p-channel field effect transistor.

As illustrated in FIG. 2, in the subpixel 100, one source/drain region of the drive transistor TR_{D} is electrically connected to one end of the capacitor C1 and the feeder line PS1m, and the other source/drain region thereof is electrically connected to one end (specifically, an anode electrode) of the light emitting element ELP. A gate electrode of the drive transistor TR_{D} is connected to the other source/drain region of the write transistor TR_{W}, and is electrically connected to the other end of the capacitor C1.

In addition, as illustrated in FIG. 2, one source/drain region of the write transistor TRw is electrically connected to the signal line DTLn, and a gate electrode of the write transistor TRw is electrically connected to the scanning line SCLm.

In addition, as illustrated in FIG. 2, the other end (specifically, a cathode electrode) of the light emitting element ELP is electrically connected to the common feeder line PS2. Furthermore, a predetermined cathode voltage Vcat is supplied to the common feeder line PS2. Note that, in FIG. 2, a capacitance of the light emitting element ELP is represented by a reference sign C_{EL}.

An outline of drive of the subpixel 100 will be described. When the write transistor TRw is brought into a conductive state by a scanning signal from the horizontal drive circuit 11 in a state where a voltage corresponding to a luminance of an image to be displayed on the signal line DTLn is supplied from the vertical drive circuit 12, a voltage corresponding to the luminance is written in the capacitor C1. The write transistor TRw is brought into a non-conductive state, and then a current flows through the drive transistor TR_{D} according to a voltage held in the capacitor C1, whereby the light emitting element ELP emits light.

Note that, in the embodiment of the present disclosure, the configuration of the drive circuit that controls light emission of the light emitting element ELP is not limited to the configuration illustrated in FIG. 2. Therefore, the configuration illustrated in FIG. 2 is merely an example, and the light emitting device 10 according to the embodiment of the present disclosure can have various configurations.

### <<2. Background leading to creation of embodiment of present disclosure>>

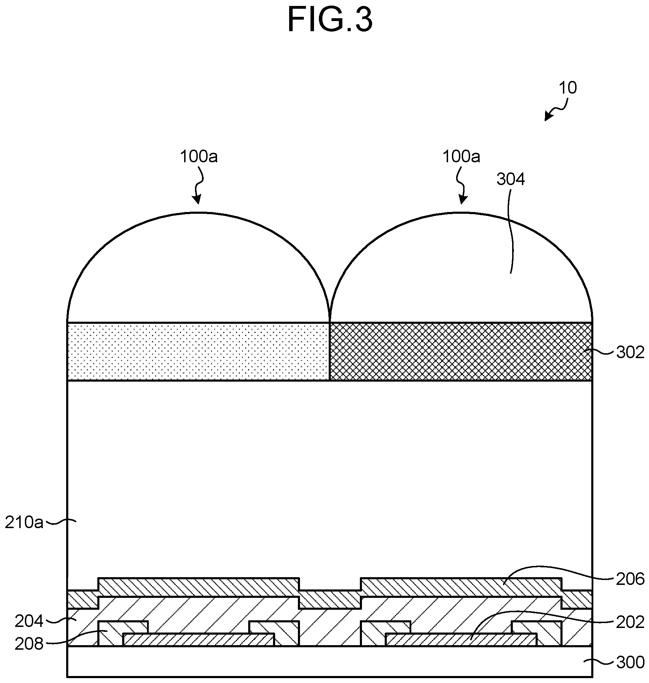

Next, before the embodiment of the present disclosure is described with reference to FIG. 3, a background leading to creation of the embodiment of the present disclosure by the present inventors will be described. FIG. 3 is a cross-sectional view for explaining an example of a configuration of a subpixel 100a according to Comparative Example. Note that, here, Comparative Example means the subpixel 100a that the present inventors had repeatedly studied before the embodiment of the present disclosure was made.

As described above, the light emitting device 10 includes the plurality of pixels 20 arranged on a substrate 300, and for example, each of the pixels 20 is constituted by a combination of three types of subpixels 100 as illustrated in FIG. 1. Here, the three types of subpixels 100a include a subpixel 100R that emits red light, a subpixel 100G that emits green light, and a subpixel 100B that emits blue light. Note that, in Comparative Example, the number and arrangement of the subpixels 100R, the number and arrangement of the subpixels 100G, and the number and arrangement of the subpixels 100B, the subpixels 100R, 100G, and 100B being three types of subpixels included in one pixel 20, are not particularly limited.

Furthermore, as illustrated in FIG. 3, each subpixel 100a according to Comparative Example includes an anode electrode (first electrode) 202 disposed on the substrate 300, a light emitting layer 204 laminated on the anode electrode 202, a cathode electrode (second electrode) 206 that is laminated on the light emitting layer 204 and transmits light from the light emitting layer 204, and a protective film 210a that is laminated on the cathode electrode 206 and transmits light from the light emitting layer 204. Furthermore, a peripheral portion (outer peripheral portion) of the anode electrode 202 is covered with an insulating film 208 that separates regions of the subpixels 100 from each other. In addition, the light emitting layer 204, the cathode electrode 206, and the protective film 210a are disposed so as to be continuous between the adjacent subpixels 100a.

In addition, as illustrated in FIG. 3, in the subpixel 100a, a color filter 302 and an on-chip lens 304 are disposed on the protective film 210a for each subpixel 100a.

In such a subpixel 100a according to Comparative Example, when a predetermined voltage is supplied to the anode electrode 202 and the cathode electrode 206, the light emitting layer 204 interposed between the anode electrode 202 and the cathode electrode 206 emits light. Specifically, in Comparative Example, light is emitted from the light emitting layer 204 in a direction from the anode electrode 202 toward the cathode electrode 206. In other words, the subpixel 100a according to Comparative Example can be said to be a top emission type light emitting element.

The present inventors have intensively studied to further improve light extraction efficiency from each subpixel 100a in such a subpixel 100a. In the subpixel 100a according to Comparative Example, since an emitting angle of light from the light emitting layer 204 in FIG. 3 is large and the light is widely diffused, there is a limit in improving the upward light extraction efficiency of the light emitting device 10 in the drawing. Furthermore, in Comparative Example, since a difference in refractive index between elements constituting the subpixel 100a is large and light is reflected by an interface between the elements, it is difficult to extract light upward in the drawing. In such a situation, the present inventors have focused on the shape of the protective film 210a, and have created the embodiment of the present disclosure capable of improving the upward light extraction efficiency in the drawing.

By the way, in a light emitting device (for example, inventions disclosed in the above Patent Literatures 1 and 2) according to prior art, the protective film 210a is divided into the subpixels 100a, or a deep groove is formed. However, according to the study of the present inventors, in the protective film 210a having such a form, light from the light emitting layer 204 cannot be efficiently guided upward. Furthermore, since the light emitting layer 204 or the like of the subpixel 100a is exposed from a side surface of the protective film 210a, it is also difficult to protect the subpixel 100 from deterioration with the protective films 210a proposed in prior art.

Hereinafter, details of the embodiment of the present disclosure that can improve the light extraction efficiency, created by the present inventors will be sequentially described.

### <<3. First embodiments

### <3.1 Detailed configuration>

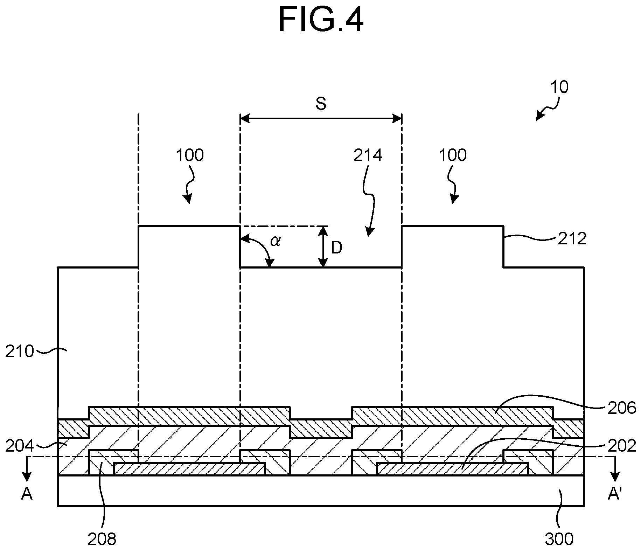

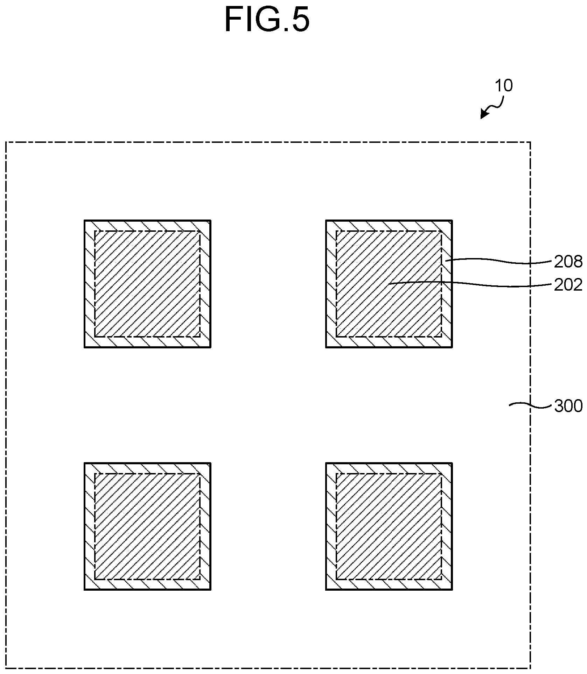

First, a detailed configuration of a subpixel (light emitting element) 100 in a first embodiment of the present disclosure will be described with reference to FIGS. 4 and 5. FIG. 4 is a cross-sectional view for explaining an example of a cross-sectional configuration of the subpixel 100 according to the first embodiment of the present disclosure, and specifically, is a cross-sectional view of the subpixel 100 cut along a thickness direction of a substrate 300. FIG. 5 is a cross-sectional view for explaining an example of a planar configuration of the subpixel 100 according to the present embodiment, and specifically, is a cross-sectional view of the subpixel 100 cut along line A-A' illustrated in FIG. 4.

In the first embodiment of the present disclosure, as described above, a pixel 20 is constituted by combining three types of subpixels 100R, 100G, and 100B that are arranged on the substrate 300 and emit light having different colors. Here, it is assumed that the subpixel 100R can emit red light (for example, visible light having a wavelength of about 640 nm to 770 nm), the subpixel 100G can emit green light (for example, visible light having a wavelength of about 490 nm to 550 nm), and the subpixel 100B can emit blue light (for example, visible light having a wavelength of about 430 nm to 490 nm). Note that, in the present embodiment, the number and arrangement of the subpixels 100R, the number and arrangement of the subpixels 100G, and the number and arrangement of the subpixels 100B, the subpixels 100R, 100G, and 100B being three types of subpixels included in one pixel 20, are not particularly limited. Furthermore, in the present embodiment, the pixel 20 may include a subpixel 100 that emits light other than red light, blue light, and green light.

Furthermore, as illustrated in FIG. 4, the subpixel 100 includes an anode electrode (first electrode) 202 disposed on the substrate 300, a light emitting layer 204 that is laminated on the anode electrode 202 and emits light, a cathode electrode (second electrode) 206 that is laminated on the light emitting layer 204 and transmits light from the light emitting layer 204, and a protective film 210 that is laminated on the cathode electrode 206 and transmits light from the light emitting layer 204. Furthermore, as illustrated in FIG. 4, the light emitting layer 204, the cathode electrode 206, and the protective film 210 are disposed so as to be continuous between the adjacent subpixels 100.

Specifically, the substrate 300 can be formed of, for example, a glass substrate such as high strain point glass, soda glass, borosilicate glass, forsterite, lead glass, or quartz glass, a semiconductor substrate such as single crystal silicon, amorphous silicon, or polycrystalline silicon, or a resin substrate such as polymethyl methacrylate, polyvinyl alcohol, polyvinyl phenol, polyether sulfone, polyimide, polycarbonate, polyethylene terephthalate, or polyethylene naphthalate.

In addition, the anode electrode 202 may also have a function as a reflection layer, and is preferably formed of a metal film having as high a reflectance as possible and a large work function in order to enhance light extraction efficiency. Examples of such a metal film include a metal film containing at least one of simple substances and alloys of metal elements such as chromium (Cr), gold (Au), platinum (Pt), nickel (Ni), copper (Cu), molybdenum (Mo), titanium (Ti), tantalum (Ta), aluminum (Al), magnesium (Mg), iron (Fe), tungsten (W), and silver (Ag). In addition, specific examples of the alloy include an aluminum (Al) alloy such as an AlNi alloy or an AlCu alloy, and a silver (Ag) alloy such as an MgAg alloy. Furthermore, the anode electrode 202 may be formed of a transparent conductive film such as indium tin oxide (ITO), indium zinc oxide (IZO), or zinc oxide (ZnO).

Furthermore, as illustrated in FIG. 4, a peripheral portion (outer peripheral portion) of the anode electrode 202 is covered with an insulating film (pixel separation film) 208 that separates regions of the subpixels 100 from each other. The insulating film 208 is formed of, for example, an oxide film such as silicon oxide (SiO₂), a nitride film such as silicon nitride (SiN), silicon oxynitride (SiON), or a laminated film thereof.

The light emitting layer 204 disposed on the anode electrode 202 is formed of an organic material or an inorganic material, and can emit white light. In addition, the light emitting layer 204 may include a hole injection layer (not illustrated) and a hole transport layer (not illustrated) disposed adjacent to the anode electrode 202, and an electron transport layer (not illustrated) disposed adjacent to the cathode electrode 206. In other words, the light emitting layer 204 can have a structure in which the hole injection layer, the hole transport layer, the light emitting layer 204, and the electron transport layer (not illustrated) are laminated from the anode electrode 202 side. Note that the hole injection layer functions as a layer that enhances hole injection efficiency into the light emitting layer 204, and also functions as a buffer layer for suppressing leakage. The hole transport layer functions as a layer that enhances hole transport efficiency to the light emitting layer 204. In addition, in the light emitting layer 204, generation of an electric field causes recombination of electrons and holes, and the light emitting layer 204 can generate light. The electron transport layer functions as a layer that enhances electron transport efficiency to the light emitting layer 204. Furthermore, the light emitting layer 204 may include an electron injection layer (not illustrated) between the electron transport layer and the cathode electrode 206. The electron injection layer functions as a layer that enhances electron injection efficiency.

Note that, in the present embodiment, the configuration of the light emitting layer 204 is not limited to the above-described configuration, and a layer other than the hole injection layer and the light emitting layer 204 can be disposed as necessary. In addition, in the present embodiment, the light emitting layers 204 of the light emitting elements 200 of all the subpixels 100 may be formed so as to have the same structure or may be formed so as to have different structures, and are not particularly limited.

In addition, in the present embodiment, the light emitting layer 204 is not limited to a layer that emits white light, and may be a layer that emits red light, blue light, or green light. That is, the light emitting layers 204 of the subpixels 100 may emit light having wavelengths different from each other.

In addition, the cathode electrode 206 disposed on the light emitting layer 204 is a transparent electrode having transparency to light generated in the light emitting layer 204, and in the following description, the transparent electrode also includes a semi-transparent electrode. The cathode electrode 206 can be formed of a metal film containing at least one of simple substances and alloys of metal elements such as aluminum (Al), magnesium (Mg), calcium (Ca), sodium (Na), and silver (Ag). Specific examples of the alloy include an aluminum (Al) alloy such as an MgAg alloy or an AlLi alloy, and a silver (Ag) alloy. Furthermore, the cathode electrode 206 may be formed of a transparent conductive film such as indium tin oxide (ITO), indium zinc oxide (IZO), or zinc oxide (ZnO).

In addition, the protective film 210 disposed on the cathode electrode 206 is a film that protects a laminate including the anode electrode 202, the light emitting layer 204, and the cathode electrode 206 from external contamination. Furthermore, the protective film 210 is formed of a transparent material having transparency to light generated in the light emitting layer 204 and having a high refractive index. For example, the protective film 210 is formed of, for example, a material having a refractive index of about 1.7 to 2.1 with respect to light having a wavelength of about 450 nm at room temperature. The protective film 210 is formed of, for example, a nitride film such as silicon nitride (SiN), an oxide film such as silicon oxynitride (SiON) or aluminum oxide (AlOₓ), a transparent conductive film such as indium tin oxide (ITO), indium zinc oxide (IZO), or zinc oxide (ZnO), a transparent organic film, or a laminated film thereof.

In addition, as illustrated in FIG. 4, the protective film 210 has a plurality of protrusions 212 and recesses 214 on an upper surface (front surface) in the drawing. In the present embodiment, the protrusion 212 is formed in an upper portion of each subpixel 100. Specifically, a center of the protrusion 212 is set so as to overlap with a center of the subpixel 100. Furthermore, the recess 214 is formed between the adjacent subpixels 100, and specifically, a part of the recess (specifically, a recess adjacent to the protrusion 212 formed in an upper portion of the subpixel 100) 214 overlaps with a peripheral portion of the anode electrode 202 covered with the insulating film 208 as illustrated in FIGS. 4 and 5. Note that a broken line in FIG. 5 indicates a region of the recess 214.

In addition, in the present embodiment, a width S (see FIG. 4) of the recess 214 has a length of a half or more of a wavelength of light emitted from the light emitting layer 204. Furthermore, a depth D (see FIG. 4) of the recess 214 is 0.1 µm or more, and preferably about 0.3 µm. According to an optical simulation by the inventors, it has been found that when the depth D of the recess 214 is 0.3 µm, the light extraction efficiency is improved about 1.4 times as compared with that of the above-described Comparative Example. In addition, in the present embodiment, a side surface of the recess 214 is not limited to being flat as illustrated in FIG. 4, and may have, for example, unevenness.

In addition, in the present embodiment, an angle α (see FIG. 4) of the side surface of the recess 214 with respect to a bottom surface of the recess 214 is 70 degrees or more and 110 degrees or less, and is preferably about 90 degrees. Note that, when the angle α is 90 degrees or more, a side surface of the protrusion 212 (that is, the side surface of the recess 214) may have a stepped shape.

As described above, in the present embodiment, light from the light emitting layer 204 is reflected by the side surface of the protrusion 212 (specifically, an interface between the protrusion 212 and the recess 214) and guided to an upper front of the subpixel 100 by the protective film 210 having the recess 214 and the protrusion 212 described above. In other words, the protrusion 212 functions as a waveguide that guides light from the light emitting layer 204 to the upper front of the subpixel 100. In addition, in the present embodiment, by forming the recess 214 such that a part of the recess 214 overlaps with a peripheral portion of the anode electrode 202 covered with the insulating film 208, most of light from the light emitting layer 204 can be suitably reflected by the side surface of the protrusion 212 and guided to the upper front of the subpixel 100. As a result, according to the present embodiment, it is possible to improve the upward light extraction efficiency of the light emitting device 10.

Furthermore, in the present embodiment, as illustrated in FIG. 5, each subpixel 100 preferably has a square shape (square arrangement) when viewed from above the substrate 300 (plan view), and the length of one side (that is, the width d) is preferably about several µm. In addition, a distance between the subpixels 100 is preferably about 2 µm or less. Note that, in the present embodiment, the shape of the light emitting element 200 in plan view is not limited to a rectangular shape, and may be, for example, a polygonal shape such as a triangle or a hexagon.

In addition, in the present embodiment, as illustrated in FIG. 5, the subpixels 100 are arranged in a square arrangement in which the subpixels 100 are arranged at vertices of a square, respectively. Note that, in the present embodiment, the arrangement is not limited to the square arrangement, and may be a delta arrangement in which the plurality of subpixels 100 are arranged at vertices of a triangle, or may be a stripe arrangement in which the subpixels 100 are arranged in a stripe shape.

Note that the present embodiment is not limited to the configuration illustrated in FIGS. 4 and 5, and can be appropriately changed according to desired characteristics.

### <3.2 Modification>

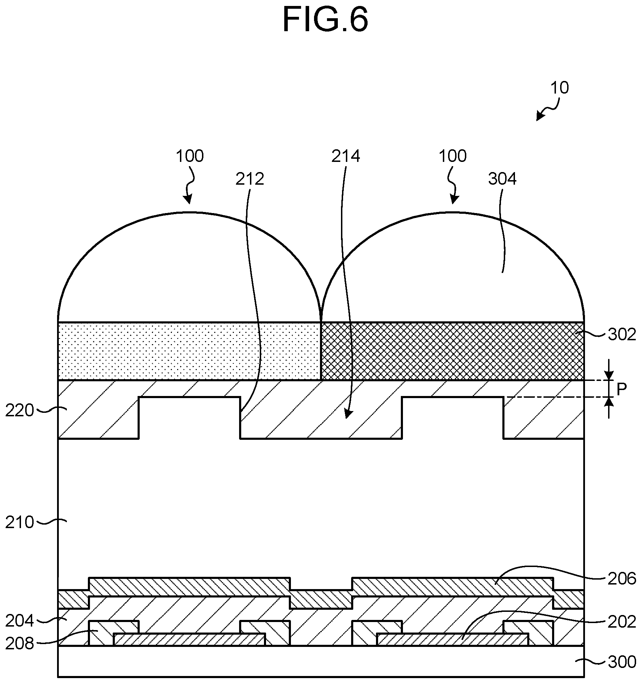

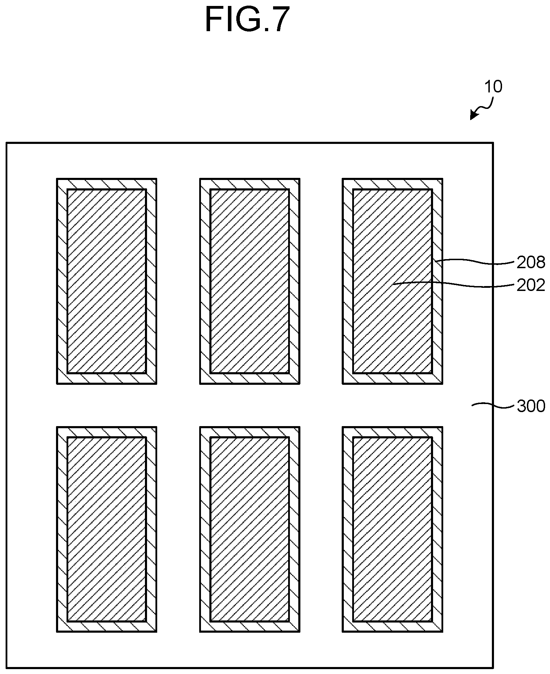

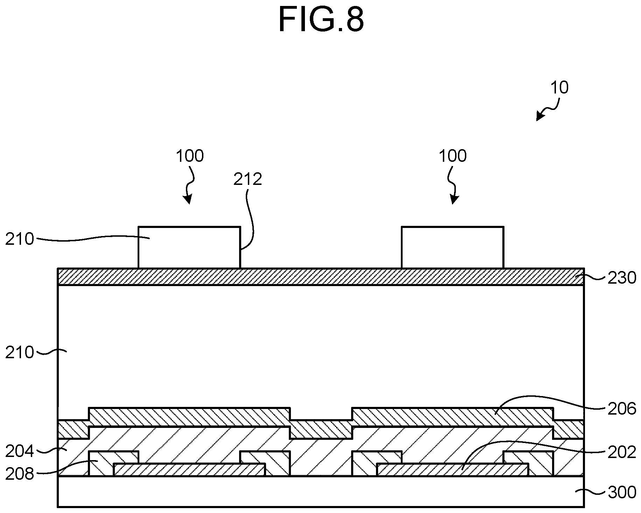

Next, a detailed configuration of a subpixel 100 in Modification of the present embodiment will be described with reference to FIGS. 6 to 8. FIG. 6 is a cross-sectional view for explaining an example of a cross-sectional configuration of a subpixel 100 according to Modification 1 of the present embodiment, and specifically, is a cross-sectional view of the subpixel 100 cut along a thickness direction of the substrate 300. FIG. 7 is a cross-sectional view for explaining an example of a planar configuration of a subpixel 100 according to Modification 2 of the present embodiment, and specifically, is a cross-sectional view of the subpixel 100 cut along line A-A' illustrated in FIG. 4. FIG. 8 is a cross-sectional view for explaining an example of a cross-sectional configuration of a subpixel 100 according to Modification 3 of the present embodiment, and specifically, is a cross-sectional view of the subpixel 100 cut along a thickness direction of the substrate 300.

### (Modification 1)

First, as illustrated in FIG. 6, the subpixel 100 according to the present Modification may include a planarizing film 220 embedded between the adjacent subpixels 100 and formed so as to cover the subpixels 100. Specifically, the planarizing film 220 is formed on the protrusion 212 so as to be embedded in the recess 214 of the protective film 210 and to cover an upper surface of the protective film 210. Note that the planarizing film 220 covering the protrusion 212 is less likely to affect light that is perpendicularly incident on the upper surface of the protrusion 212, but may reflect light that is obliquely incident. However, in a case where the film thickness of the planarizing film 220 on the protrusion 212 is sufficiently thinner than a half of the wavelength of light, the planarizing film 220 is transparent to light, and therefore reflection as described above can be suppressed. Therefore, in the present embodiment, the film thickness P of the planarizing film 220 on the protrusion 212 is preferably a half or less of the wavelength of light emitted from the light emitting layer 204.

Furthermore, the planarizing film 220 is formed of a material having a refractive index lower than that of the protective film 210. Specifically, the planarizing film 220 is formed of a material having a refractive index having a difference of 0.1 or more with respect to the protective film 210, more preferably formed of a material having a refractive index having a difference of 0.2 or more, and still more preferably formed of a material having a refractive index having a difference of 0.3 or more. Note that, according to an optical simulation by the inventors, in a case where the planarizing film 220 is formed of a material having a refractive index having a difference of 0.3 or more with respect to the protective film 210, the light extraction efficiency is improved 1.4 times as compared with that of the above-described Comparative Example. In addition, the planarizing film 220 can be formed of, for example, an oxide film such as silicon oxide (SiO₂) or aluminum oxide (AlOₓ), or a resin film.

Furthermore, in the present Modification 1, as illustrated in FIG. 6, the color filter 302 and the on-chip lens 304 are disposed above the planarizing film 220 for each subpixel 100. Specifically, the color filter 302 can be constituted by a color filter that transmits a red wavelength component, a color filter that transmits a green wavelength component, or a color filter that transmits a blue wavelength component. For example, the color filter 302 can be formed of a material in which a pigment or a dye is dispersed in a transparent binder such as silicone. The on-chip lens 304 can be formed of a styrene-based resin, an acrylic resin, a styrene-acrylic copolymer-based resin, a siloxane-based resin, or the like. Note that, in the present Modification, when the light emitting layer 204 is a layer that emits red light, blue light, or green light, the color filter 302 does not have to be disposed.

### (Modification 2)

In the present Modification, as illustrated in FIG. 7, the plurality of subpixels 100 may each have a rectangular shape when viewed from above the substrate 300 (in plan view), and may be arranged so as to form a stripe shape (stripe arrangement).

### (Modification 3)

In the present Modification, the protective film 210 may be a laminated film formed of different materials. For example, as illustrated in FIG. 8, the protective film 210 includes an etching stopper film (etching stopper layer) 230, and the protrusion 212 is formed on the etching stopper film 230. That is, in the present Modification, the protective film having the protrusion 212 and the recess 214 is constituted by a laminated layer of the protective film 210 and the etching stopper film 230.

In a case where the protective film 210 is formed of silicon nitride (SiN), the etching stopper film 230 can be formed of silicon oxide (SiO₂), aluminum oxide (Al₂O₃), or the like. In addition, in a case where the protective film 210 is formed of silicon oxide (SiO₂) or aluminum oxide (Al₂O₃), the etching stopper film 230 can be formed of silicon nitride (SiN) or the like. That is, in the present Modification, the protective film having the protrusion 212 and the recess 214 is formed of a laminated layer of materials having different etching rates. As a result, when the protrusion 212 and the recess 214 are formed by photolithography and etching, etching is stopped at the etching stopper film 230, and therefore the depth of the recess 214 or the height of the protrusion 212 can be accurately adjusted. Note that the etching stopper film 230 is preferably formed by an atomic layer deposition (ALD) method from a viewpoint of ensuring stop of etching and protecting each laminated film of the subpixel 100. In addition, the film thickness of the etching stopper film 230 only needs to be, for example, 10 nm or more and 100 nm or less.

### <3.3 Manufacturing method>

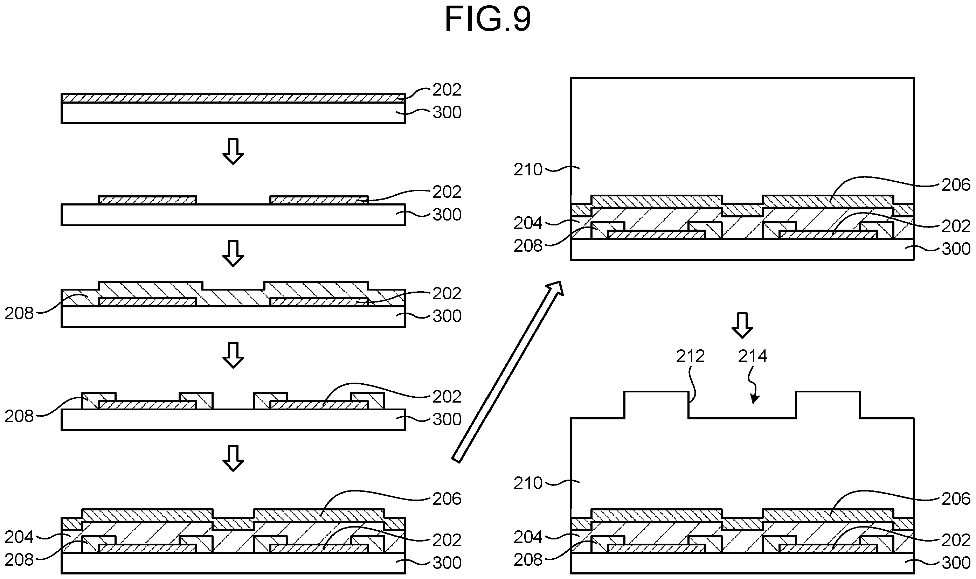

Next, a method for manufacturing the subpixel 100 of the present embodiment will be described with reference to FIG. 9. FIG. 9 is a cross-sectional view for explaining the method for manufacturing the subpixel 100 according to the present embodiment, and corresponds to the cross-sectional view of FIG. 4.

First, as illustrated in the highest part on the left side in the drawing, a film to be a material of the anode electrode 202 is laminated on the substrate 300. Next, as illustrated in the second highest part on the left side in the drawing, the material is etched using a mask patterned by photolithography to form the anode electrode 202 having a desired shape at a desired position.

Next, as illustrated in the third highest part on the left side in the drawing, the insulating film 208 is laminated on the substrate 300 and the anode electrode 202. Furthermore, as illustrated in the fourth highest part on the left side in the drawing, the insulating film 208 is etched using a mask patterned by photolithography, and the insulating film 208 is left only in a peripheral portion of the anode electrode 202.

Next, as illustrated in the lowest part on the left side in the drawing, the light emitting layer 204 and the cathode electrode 206 are sequentially laminated on the anode electrode 202 whose peripheral portion is covered with the insulating film 208 and the substrate 300.

Furthermore, as illustrated in the upper part on the right side in the drawing, the protective film 210 is laminated on the cathode electrode 206. Furthermore, as illustrated in the lower part on the right side in the drawing, an upper surface of the protective film 210 is etched using a mask patterned by photolithography to form the protective film 210 having the protrusion 212 and the recess 214.

### <<4. Second embodiments

### <4.1 Detailed configuration>

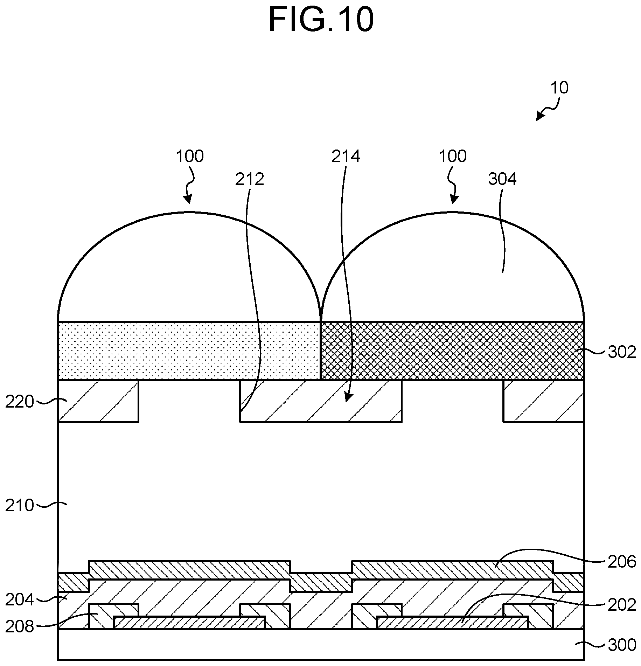

In the first embodiment described above, the upper surface of the protrusion 212 of the protective film 210 is covered with the planarizing film 220, but the present disclosure is not limited thereto, and the upper surface of the protrusion 212 of the protective film 210 may be in contact with the color filter 302. Therefore, such a configuration of a subpixel 100 in a second embodiment will be described with reference to FIG. 10. FIG. 10 is a cross-sectional view for explaining an example of a cross-sectional configuration of the subpixel 100 according to the present embodiment, and specifically, is a cross-sectional view of the subpixel 100 cut along a thickness direction of a substrate 300. Note that, in the following description, description of parts common to the first embodiment is omitted.

Also in the present embodiment, as in the first embodiment, as illustrated in FIG. 10, the subpixel 100 includes an anode electrode 202 disposed on the substrate 300 and having a peripheral portion covered with an insulating film 208, a light emitting layer 204 that is laminated on the anode electrode 202 and emits light, a cathode electrode 206 that is laminated on the light emitting layer 204 and transmits light from the light emitting layer 204, and a protective film 210 that is laminated on the cathode electrode 206 and transmits light from the light emitting layer 204.

Furthermore, also in the present embodiment, as in the first embodiment, as illustrated in FIG. 10, the protective film 210 has a protrusion 212 and a recess 214 on an upper surface (surface) in the drawing. In addition, also in the present embodiment, the recess 214 is formed between the adjacent subpixels 100, and a part of the recess 214 overlaps with the peripheral portion of the anode electrode 202 covered with the insulating film 208.

However, in the present embodiment, unlike the first embodiment, a planarizing film 220 is embedded only in the recess 214 of the protective film 210, and is not formed so as to cover an upper surface of the protective film 210.

Furthermore, in the present embodiment, as illustrated in FIG. 10, a color filter 302 is disposed on the protective film 210 so as to be in direct contact with an upper surface of the protrusion 212 of the protective film 210. In the present embodiment, the color filter 302 is preferably formed of a material having a refractive index close to a refractive index of the protective film 210, specifically, a material having a refractive index difference of 0.1 or less with respect to the protective film 210.

In the present embodiment, by forming the color filter 302 formed of a material having a refractive index close to a refractive index of the protective film 210 and the protrusion 212 of the protective film 210 so as to be in direct contact with each other, light from the light emitting layer 204 is less likely to be reflected at an interface between the protective film 210 and the color filter 302. Therefore, in the present embodiment, light from the light emitting layer 204 passes through the color filter 302 from the protrusion 212 and is guided to an upper front of the subpixel 100. As a result, according to the present embodiment, it is possible to further improve upward light extraction efficiency of the light emitting device 10.

Note that, in the present embodiment, another film may be disposed between the protrusion 212 and the color filter 302. In such a case, the other film is preferably formed of a material having a refractive index close to a refractive index of the protective film 210, specifically, a material having a refractive index difference of 0.1 or less with respect to the protective film 210.

Note that the present embodiment is not limited to the configuration illustrated in FIG. 10, and can be appropriately changed according to desired characteristics.

### <4.2 Manufacturing method>

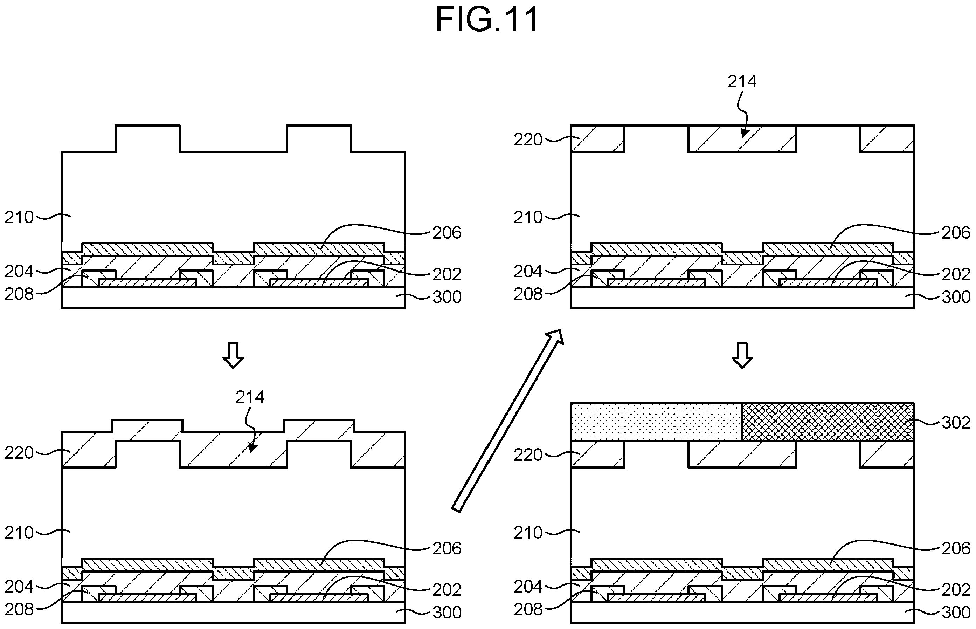

Next, a method for manufacturing the subpixel 100 of the present embodiment will be described with reference to FIG. 11. FIG. 11 is a cross-sectional view for explaining the method for manufacturing the subpixel 100 according to the present embodiment, and corresponds to the cross-sectional view of FIG. 10.

First, as illustrated in the upper part on the left side in the drawing, the protective film 210 having the protrusion 212 and the recess 214 is formed according to the method for manufacturing the subpixel 100 in the first embodiment.

Next, as illustrated in the lower part on the left side in the drawing, the planarizing film 220 is laminated on the protective film 210. Next, as illustrated in the upper part on the right side in the drawing, the planarizing film 220 protruding from the recess 214 is removed by etching, chemical mechanical polishing (CMP), or the like to planarize a surface.

Furthermore, as illustrated in the lower part on the right side in the drawing, the color filter 302 is formed on the protective film 210 and the planarizing film 220.

### <4.3 Modification>

### (Detailed configuration)

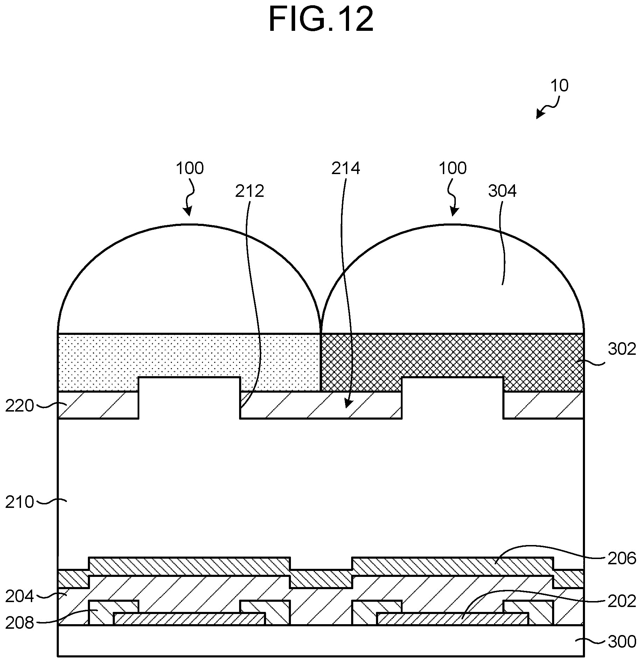

Next, a detailed configuration of a subpixel 100 in Modification of the present embodiment will be described with reference to FIG. 12. FIG. 12 is a cross-sectional view for explaining an example of a cross-sectional configuration of the subpixel 100 according to Modification of the present embodiment, and specifically, is a cross-sectional view of the subpixel 100 cut along a thickness direction of the substrate 300.

In the present Modification, as illustrated in FIG. 12, the color filter 302 is not only in direct contact with an upper surface of the protrusion 212 of the protective film 210 but also may have a surface (lower surface in the drawing) having unevenness engaged with the protrusion 212 of the protective film 210.

As described above, also in the present Modification, by forming the color filter 302 formed of a material having a refractive index close to a refractive index of the protective film 210 and the protrusion 212 of the protective film 210 so as to be in direct contact with each other, light from the light emitting layer 204 is less likely to be reflected at an interface between the protective film 210 and the color filter 302. Therefore, in the present Modification, light from the light emitting layer 204 passes through the color filter 302 from the protrusion 212 and is guided to an upper front of the subpixel 100. As a result, according to the present Modification, it is possible to further improve the upward light extraction efficiency of the light emitting device 10.

### (Manufacturing method)

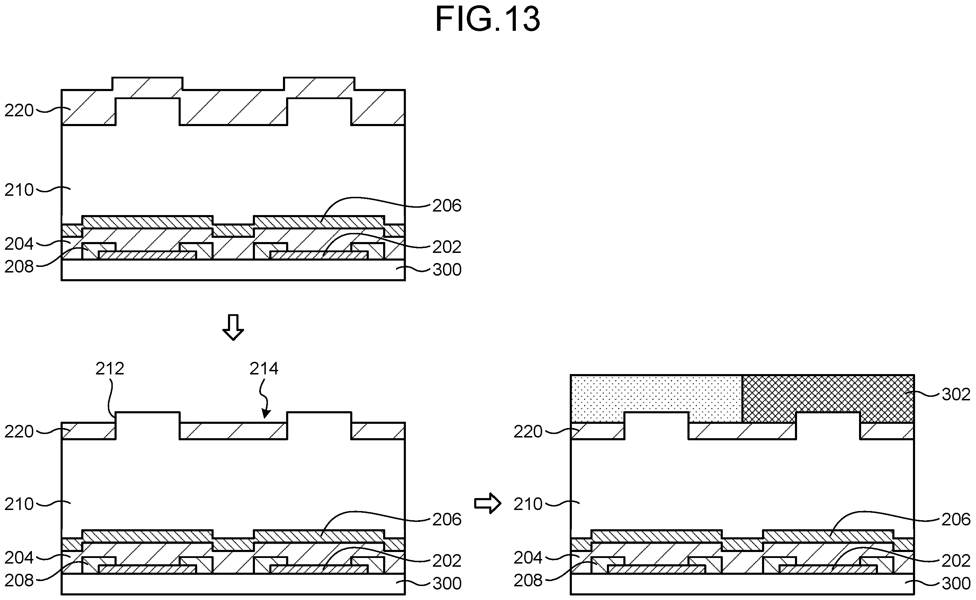

Next, a method for manufacturing the subpixel 100 according to Modification of the present embodiment will be described with reference to FIG. 13. FIG. 13 is a cross-sectional view for explaining the method for manufacturing the subpixel 100 according to Modification of the present embodiment, and corresponds to the cross-sectional view of FIG. 12.

First, the protective film 210 having the protrusion 212 and the recess 214 is formed according to the method for manufacturing the subpixel 100 in the first embodiment. Next, as illustrated in the upper part on the left side in the drawing, the planarizing film 220 is laminated on the protective film 210.

Furthermore, as illustrated in the lower part on the left side in the drawing, the planarizing film 220 protruding from the recess 214 is removed by etching, CMP, or the like to planarize a surface, and an upper side of the planarizing film 220 in the recess 214 is further removed.

Furthermore, as illustrated on the right side in the drawing, the color filter 302 is formed on the protective film 210 and the planarizing film 220.

### <<5. Third embodiments

### <5.1 Detailed configuration>

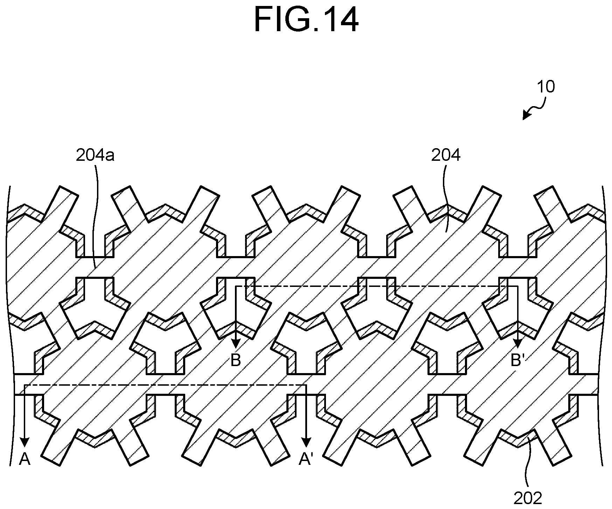

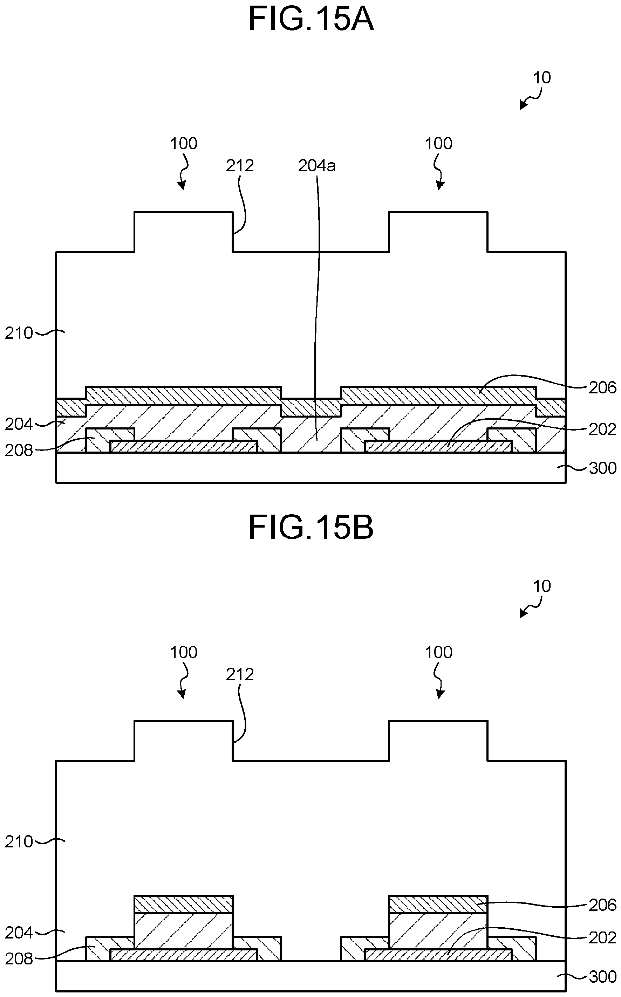

In the present disclosure, the light emitting layer 204 may be divided into the subpixels 100, or may be divided but parts thereof may be connected to each other. Therefore, such a configuration of a subpixel 100 in a third embodiment will be described with reference to FIGS. 14, 15A, and 15B. FIG. 14 is a cross-sectional view for explaining an example of a planar configuration of the subpixel 100 according to the present embodiment, and specifically corresponds to FIG. 5. FIGS. 15A and 15B are cross-sectional views for explaining an example of a cross-sectional configuration of the subpixel 100 according to the present embodiment. Specifically, FIG. 15A is a cross-sectional view of the subpixel 100 cut along line A-A' illustrated in FIG. 14, and FIG. 15B is a cross-sectional view of the subpixel 100 cut along line B-B' illustrated in FIG. 14.

In the present embodiment, as illustrated in FIG. 14, when viewed from above a substrate 300 (in plan view), the plurality of subpixels 100 each have a hexagonal shape and are arranged in a delta arrangement in which the subpixels 100 are arranged at vertices of a triangle, respectively. Specifically, in the present embodiment, a light emitting layer 204 of each subpixel 100 has a hexagonal shape, and is further connected to a light emitting layer 204 of the adjacent subpixel 100 by a connection portion (connection part) 204a constituted by a rectangular light emitting layer 204.

In addition, as can be seen from the cross-sectional view of the subpixel 100 cut along line A-A' illustrated as FIG. 15A, in the present embodiment, the light emitting layers 204 of the subpixels 100 are connected to each other by the connection portion 204a. Meanwhile, as can be seen from the cross-sectional view of the subpixel 100 cut along line B-B' illustrated in FIG. 15B, in the present embodiment, the light emitting layers 204 of the subpixels 100 are separated from each other. That is, in the present embodiment, the light emitting layer 204 is divided into the subpixels 100 in a portion other than the connection portion 204a.

Furthermore, also in the present embodiment, as in the first embodiment, as illustrated in FIGS. 15A and 15B, the protective film 210 has a protrusion 212 and a recess 214 on an upper surface (surface) in the drawing. In addition, also in the present embodiment, the recess 214 is formed between the adjacent subpixels 100, and a part of the recess 214 overlaps with a peripheral portion of an anode electrode 202 covered with an insulating film 208.

In a form in which the light emitting layers 204 of the subpixels 100 are separated from each other in a portion other than the connection portion 204a as in the present embodiment, it is difficult to accurately process the light emitting layers 204. Therefore, it is difficult to improve light extraction efficiency by adjusting the shapes, dimensions, and the like of various elements of the subpixel 100 while maintaining high processing accuracy of the light emitting layers 204. However, in the present embodiment, by using the protective film 210 as in the first embodiment, light from the light emitting layer 204 is reflected by a side surface of the protrusion 212 (specifically, an interface between the protrusion 212 and the recess 214) and guided to an upper front of the subpixel 100. In addition, in the present embodiment, by forming the recess 214 such that a part of the recess 214 overlaps with a peripheral portion of the anode electrode 202 covered with the insulating film 208, most of light from the light emitting layer 204 can be suitably reflected by the side surface of the protrusion 212 and guided to the upper front of the subpixel 100. As a result, according to the present embodiment, it is possible to improve the upward light extraction efficiency of the light emitting device 10.

Note that the present embodiment is not limited to the configuration illustrated in FIGS. 14, 15A, and 15B, and can be appropriately changed according to desired characteristics.

### <5.2 Manufacturing method>

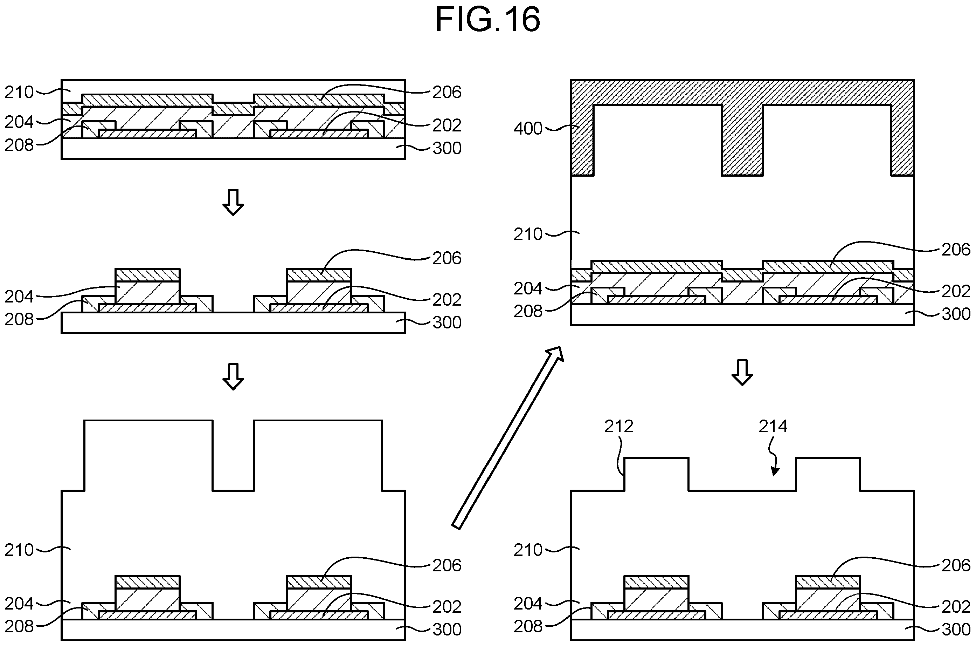

Next, a method for manufacturing the subpixel 100 according to the present embodiment will be described with reference to FIG. 16. FIG. 16 is a cross-sectional view for explaining the method for manufacturing the subpixel 100 according to the present embodiment, and corresponds to the cross-sectional view of FIG. 15B.

First, as illustrated in the highest part on the left side in the drawing, the anode electrode 202 whose peripheral portion is covered with the insulating film 208 is formed on the substrate 300, and the light emitting layer 204, the cathode electrode 206, and the protective film 210 are sequentially laminated on the anode electrode 202.

Furthermore, as illustrated in the second highest part on the left side in the drawing, the protective film 210, the cathode electrode 206, and the light emitting layer 204 are dry-etched using a mask patterned by photolithography, and the laminated layer of the protective film 210, the cathode electrode 206, and the light emitting layer 204 is divided into the subpixels 100.

Furthermore, as illustrated in the lowest part on the left side in the drawing, the protective film 210 is further laminated on the protective film 210. Next, as illustrated in the upper part on the right side in the drawing, a mask 400 is formed on the protective film 210. Furthermore, as illustrated in the lower part on the right side in the drawing, the protective film 210 is etched according to a pattern of the mask to form the protective film 210 having the protrusion 212 and the recess 214.

### <5.3 Modification>

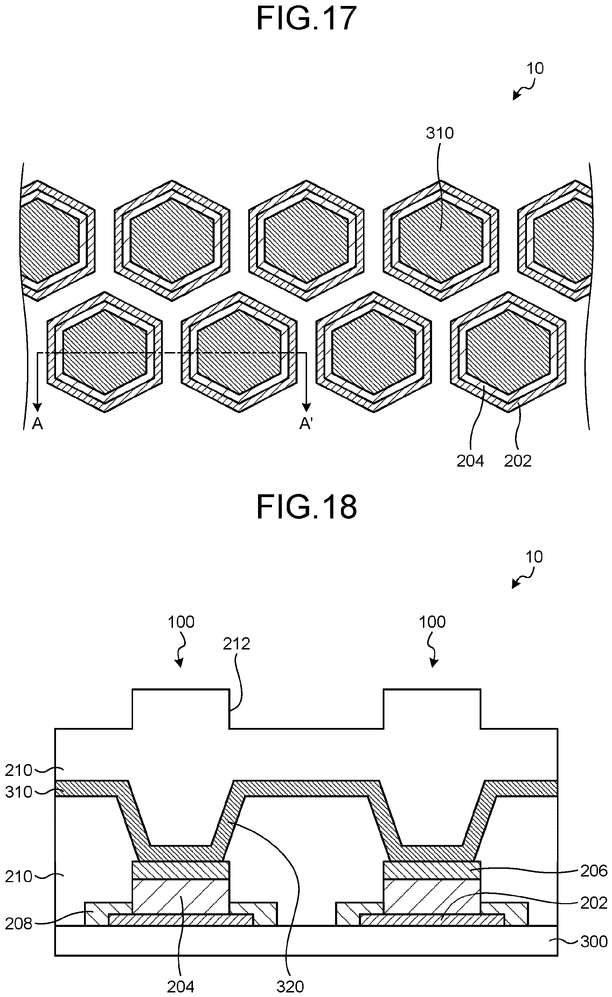

In the present embodiment, the light emitting layer 204 may be completely divided into the subpixels 100. Therefore, a detailed configuration of such a subpixel 100 in Modification of the present embodiment will be described with reference to FIGS. 17 and 18. FIG. 17 is a cross-sectional view for explaining an example of a planar configuration of the subpixel 100 according to Modification of the present embodiment, and specifically corresponds to FIG. 5. FIG. 18 is a cross-sectional view for explaining an example of a cross-sectional configuration of the subpixel 100 according to Modification of the present embodiment, and specifically, is a cross-sectional view of the subpixel 100 cut along line A-A' illustrated in FIG. 17.

In the present Modification, as in the present embodiment, as illustrated in FIG. 17, the plurality of subpixels 100 each have a hexagonal shape and are arranged in a delta arrangement in which the subpixels 100 are arranged at vertices of a triangle, respectively. However, in the present Modification, the light emitting layer 204 of each subpixel 100 has a hexagonal shape, but is separated from the light emitting layer 204 of the adjacent subpixel 100. That is, in the present Modification, the light emitting layers 204 are divided into the subpixels 100.

Furthermore, as can be seen from the cross-sectional view of the subpixel 100 cut along line A-A' illustrated as FIG. 18, in the present Modification, the cathode electrodes 206 are electrically connected to each other by an electrode (third electrode) 310 disposed in a contact hole 320 or the like penetrating the protective film 210. Furthermore, the electrode 310 can be formed of a transparent conductive film such as indium tin oxide (ITO), indium zinc oxide (IZO), or zinc oxide (ZnO).

Furthermore, also in the present Modification, as in the first embodiment, as illustrated in FIG. 18, the protective film 210 has the protrusion 212 and the recess 214 on an upper surface (surface) in the drawing. In addition, also in the present Modification, the recess 214 is formed between the adjacent subpixels 100, and a part of the recess 214 overlaps with the peripheral portion of the anode electrode 202 covered with the insulating film 208.

As in the present Modification, in a form in which the light emitting layers 204 of the subpixels 100 are separated from each other, and the cathode electrodes 206 are electrically connected to each other by the electrode 310 disposed in the contact hole 320 or the like penetrating the protective film 210, it is difficult to accurately process the subpixels 100. Therefore, it is difficult to improve the light extraction efficiency by adjusting the shapes, dimensions, and the like of various elements of the subpixel 100 while maintaining high processing accuracy of the subpixel 100. However, also in the present Modification, by using the protective film 210 as in the first embodiment, light from the light emitting layer 204 is reflected by a side surface of the protrusion 212 (specifically, an interface between the protrusion 212 and the recess 214) and guided to an upper front of the subpixel 100. In addition, also in the present Modification, by forming the recess 214 such that a part of the recess 214 overlaps with a peripheral portion of the anode electrode 202 covered with the insulating film 208, most of light from the light emitting layer 204 can be suitably reflected by the side surface of the protrusion 212 and guided to the upper front of the subpixel 100. As a result, according to the present Modification, it is possible to improve the upward light extraction efficiency of the light emitting device 10.

### <<6. Fourth embodiments

### <6.1 Detailed configuration>

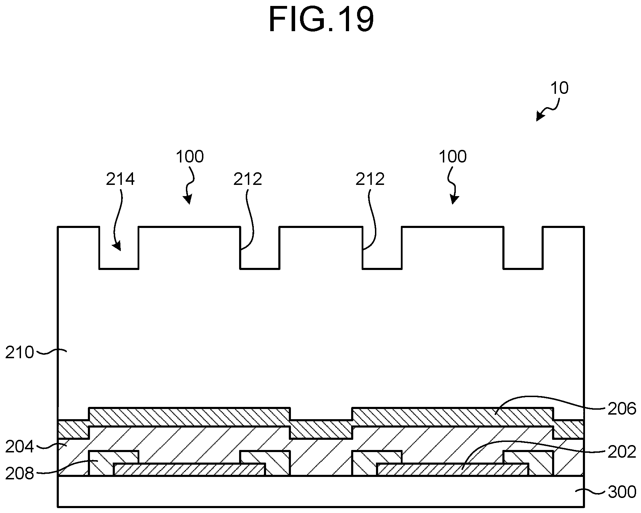

In the present disclosure, it is not limited to the configuration in which one recess 214 is formed between the adjacent subpixels 100 as in the embodiments described above, and a plurality of recesses 214 may be formed between the adjacent subpixels 100. Therefore, such a configuration of a subpixel 100 in a fourth embodiment will be described with reference to FIG. 19. FIG. 19 is a cross-sectional view for explaining an example of a cross-sectional configuration of the subpixel 100 according to the present embodiment, and specifically, is a cross-sectional view of the subpixel 100 cut along a thickness direction of a substrate 300.

Also in the present embodiment, as illustrated in FIG. 19, a protective film 210 has a protrusion 212 and a recess 214 on an upper surface (front surface) in the drawing. In the present embodiment, the protrusion 212 is formed so as to correspond to each subpixel 100, and two recesses 214 are formed between the adjacent subpixels 100. In other words, the two recesses 214 are formed with the protrusion 212 formed above the subpixel 100 interposed therebetween. Note that, also in the present embodiment, as illustrated in FIG. 19, the recess 214 overlaps a peripheral portion of an anode electrode 202 covered with an insulating film 208.

As described above, in the present embodiment, by changing the number of recesses 214 between the adjacent subpixels 100, an interface between the protrusion 212 and the recess 214 for reflecting light from the light emitting layer 204 is increased, whereby the light from the light emitting layer 204 can be more reliably guided to an upper front of the subpixels 100.

Specifically, in the embodiments described above, in a case where an inclination of a light beam from the light emitting layer 204 with respect to an optical axis of the subpixel 100 is small, light is reflected by an interface between the protrusion 212 formed above the subpixel 100 and the recess 214 adjacent to the protrusion 212, and the light is guided to an upper front of the subpixel 100. Meanwhile, in a case where the inclination of the light beam from the light emitting layer 204 with respect to the optical axis of the subpixel 100 is large, since the interface between the protrusion 212 and the recess 214 is not present on a route of the light beam, light is not guided to the upper front of the subpixel 100.

Meanwhile, in the present embodiment, even in a case where the inclination of the light beam from the light emitting layer 204 with respect to the optical axis of the subpixel 100 is large, since the interface between the protrusion 212 and the recess 214 is present on a route of the light beam, light is guided to the upper front of the subpixel 100. As a result, according to the present embodiment, it is possible to improve the upward light extraction efficiency of the light emitting device 10.

Note that the present embodiment is not limited to the configuration illustrated in FIG. 19, and can be appropriately changed according to desired characteristics.

### <6.2 Modification>

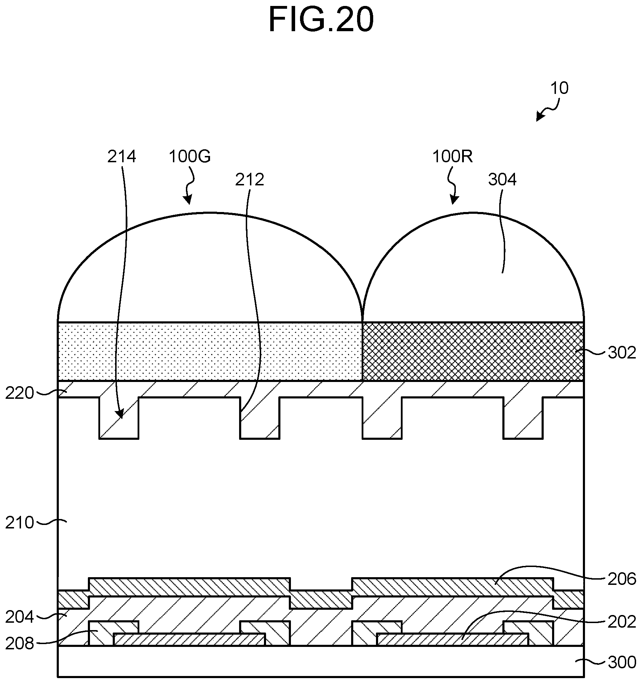

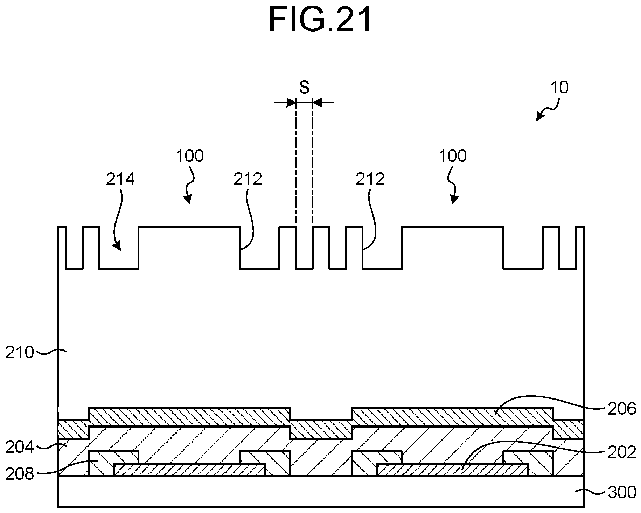

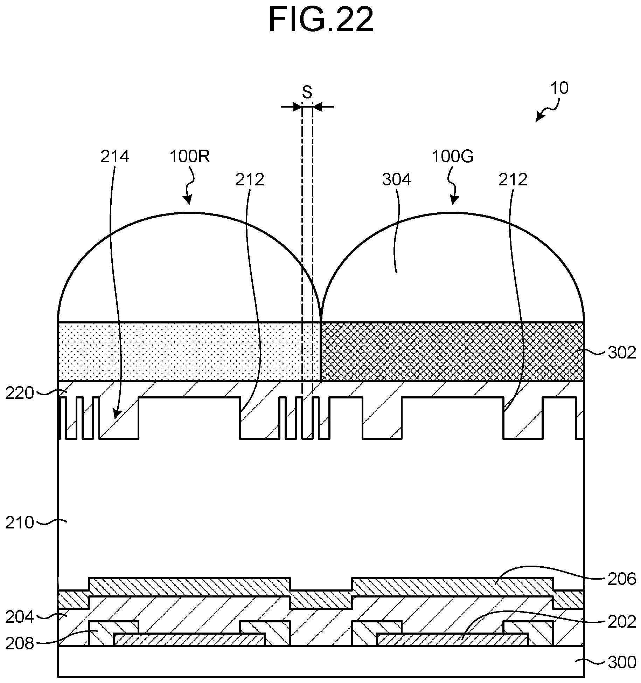

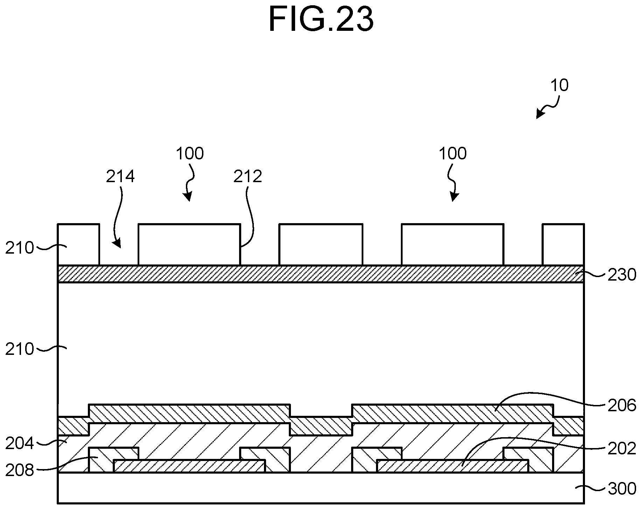

Next, a detailed configuration of a subpixel 100 in Modification of the present embodiment will be described with reference to FIGS. 20 to 23. FIG. 20 is a cross-sectional view for explaining an example of a cross-sectional configuration of a subpixel 100 according to Modification 1 of the present embodiment, and FIG. 21 is a cross-sectional view for explaining an example of a cross-sectional configuration of a subpixel 100 according to Modification 2 of the present embodiment. FIG. 22 is a cross-sectional view for explaining an example of a cross-sectional configuration of a subpixel 100 according to Modification 3 of the present embodiment, and FIG. 23 is a cross-sectional view for explaining an example of a cross-sectional configuration of a subpixel 100 according to Modification 4 of the present embodiment. These drawings are cross-sectional views of the subpixel 100 cut along the thickness direction of the substrate 300.

### (Modification 1)

As illustrated in FIG. 20, also in the present Modification, the color filter 302 and the on-chip lens 304 may be disposed above the planarizing film 220 for each subpixel 100. Note that, in the present Modification, a protrusion 212 adjacent to a protrusion 212 formed above the subpixel 100 is preferably formed at a position within 200 nm from a boundary of the color filter 302 (In FIG. 20, a right end of a protrusion 212 adjacent to a protrusion 212 formed above the subpixel 100 is present at the same position as the boundary of the color filter 302.) from a viewpoint of preventing color mixing.

With such a configuration, in the present Modification, even in a case where the inclination of the light beam from the light emitting layer 204 with respect to the optical axis of the subpixel 100 is large, since the interface between the protrusion 212 and the recess 214 is present on a route of the light beam, light is guided to the upper front of the subpixel 100. Therefore, according to the present Modification, even in a case where the inclination of the light beam from the light emitting layer 204 with respect to the optical axis of the subpixel 100 is large, the light is guided to an upper front of the subpixel 100 without reaching the adjacent subpixel 100. As a result, according to the present Modification, color mixing can be prevented.

### (Modification 2)

As illustrated in FIG. 21, in the present Modification, four recesses 214 are formed between adjacent subpixels 100. Specifically, also in the present Modification, among the recesses 214, a recess 214 adjacent to a protrusion 212 formed above the subpixel 100 overlaps with a peripheral portion of the anode electrode 202 covered with the insulating film 208 as illustrated in FIG. 21. Note that, also in the present Modification, the number formed between the adjacent subpixels 100 is not limited, and a width S of each recess 214 is not limited.

As described above, in the present Modification, by increasing the number of recesses 214 between the subpixels 100, light that cannot be reflected by an interface between the first protrusion 212 and the first recess 214 closest to a center of the subpixel 100 can be reflected by an interface between the second protrusion 212 and the second recess 214 or between the third protrusion 212 and the third recess 214 from the center of the subpixel 100, whereby light from the light emitting layer 204 is efficiently guided above the subpixel 100. As a result, according to the present Modification, it is possible to further improve the upward light extraction efficiency of the light emitting device 10.

### (Modification 3)

As illustrated in FIG. 22, in the present Modification, the number and dimensions of the recesses 214 between the adjacent subpixels 100 may be changed depending on the subpixel 100. In the present Modification, by optimizing the number and dimensions of the recesses 214 between the adjacent subpixels 100 depending on the position of the subpixel 100 on the light emitting device 10, light from each light emitting layer 204 can be guided in a suitable direction above each subpixel 100.

In addition, although not illustrated, in the present Modification, the number of the recesses 214 between the adjacent subpixels 100 may be changed, or the width and depth of each of the recesses 214 may be changed depending on a wavelength of light emitted by the light emitting layer 204. In the present Modification, by optimizing the number and dimensions (width and depth) of the recesses 214 between the adjacent subpixels 100 depending on a wavelength of light emitted by the light emitting layer 204, the light from each light emitting layer 204 can be guided above each subpixel 100.

Note that, in the present Modification, when the width of the recess 214 is reduced or the depth of the recess 214 is increased, an aspect ratio increases, and it is difficult to process the recess 214 or embed the recess 214. Therefore, in the present Modification, in consideration of such a difficulty of processing and the like, it is preferable to reduce the width of the recess 214 or to increase the depth of the recess 214 within a range where an effect can be expected.

### (Modification 4)

As illustrated in FIG. 23, also in the present Modification, the protective film 210 may include the etching stopper film (etching stopper layer) 230, and the protrusion 212 may be formed on the etching stopper film 230. With such a configuration, in the present Modification, even when an aspect ratio increases, the protrusion 212 and the recess 214 can be accurately processed.

### << 7. Fifth embodiments

### <7.1 Detailed configuration>

In the embodiments of the present disclosure described above, the protrusion 212 above the subpixel 100 is set such that a center of the protrusion 212 overlaps with a center of the subpixel 100. However, in the embodiments of the present disclosure, the configuration is not limited to a configuration in which the center of the protrusion 212 is set so as to overlap with the center of the subpixel 100, and the center of the protrusion 212 may be shifted from the center of the subpixel 100. That is, in a fifth embodiment of the present disclosure, the protrusion 212 above the subpixel 100 may be formed asymmetrically with respect to the center of the subpixel 100.

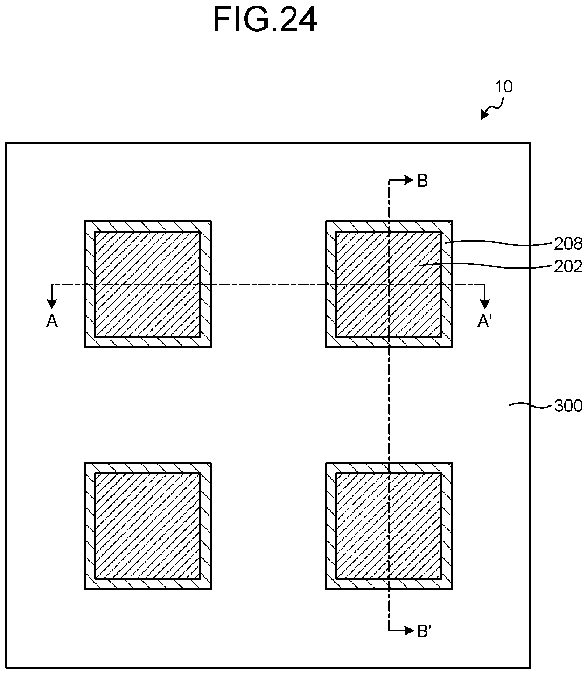

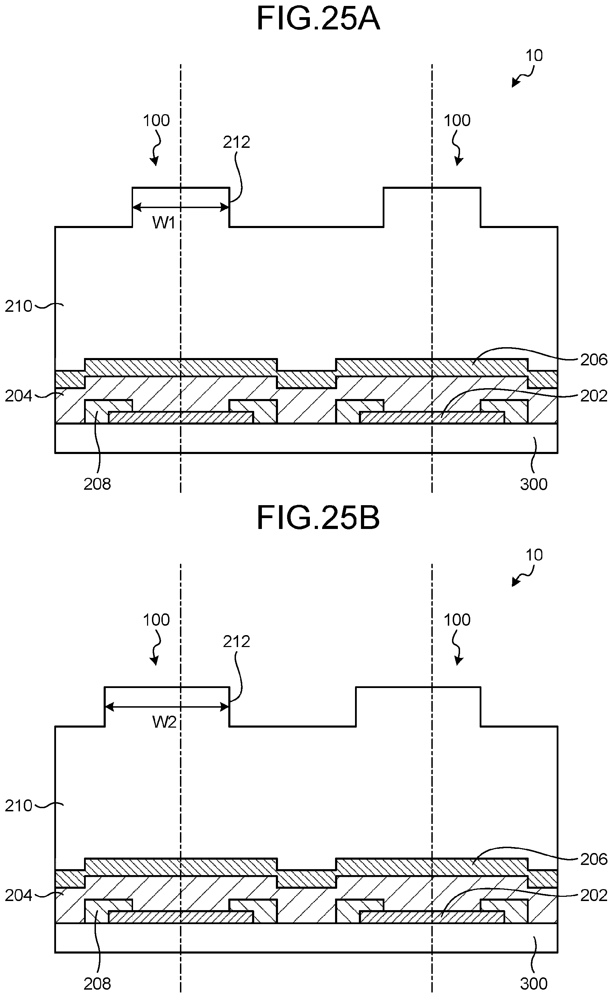

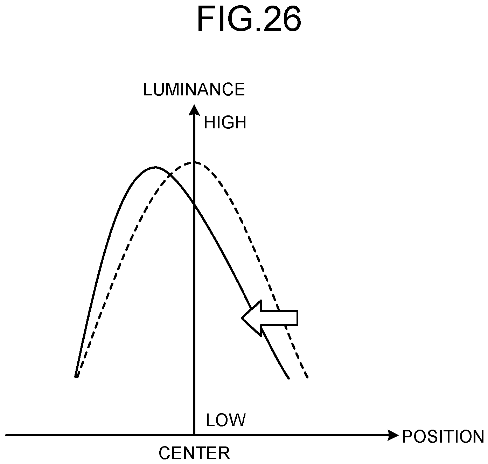

Therefore, such a configuration of the subpixel 100 in the fifth embodiment will be described with reference to FIGS. 24 to 26. FIG. 24 is a cross-sectional view for explaining an example of a planar configuration of the subpixel 100 according to the present embodiment, and specifically corresponds to FIG. 5. FIGS. 25A and 25B are cross-sectional views for explaining an example of a cross-sectional configuration of the subpixel 100 according to the present embodiment. Specifically, FIG. 25A is a cross-sectional view of the subpixel 100 cut along line A-A' illustrated in FIG. 24, and FIG. 25B is a cross-sectional view of the subpixel 100 cut along line B-B' illustrated in FIG. 24. FIG. 26 is an explanatory diagram for explaining the present embodiment.

In the present embodiment, as illustrated in FIG. 24, when viewed from above a substrate 300 (in plan view), the subpixels 100 each have a square shape (square arrangement) and are arranged in a square arrangement in which the subpixels 100 are arranged at vertices of a square, respectively.

In addition, in the present embodiment, as illustrated in FIG. 25A which is a cross-sectional view of the subpixel 100 cut along line A-A' in FIG. 24, the protrusion 212 is formed such that the center of the protrusion 212 overlaps with the center of the subpixel 100. Meanwhile, in the present embodiment, as illustrated in FIG. 25B which is a cross-sectional view of the subpixel 100 cut along line B-B' in FIG. 24, the center of the protrusion 212 is shifted from the center of the subpixel 100.

Note that, in the present embodiment, a width W1 of the protrusion 212 in the cross section cut along line A-A' is different from a width W2 of the protrusion 212 in the cross section cut along line B-B'. Note that, in the present embodiment, the widths W1 and W2 of the protrusion 212 may be the same, and are not particularly limited. In addition, in the examples of FIGS. 25A and 25B, the center of the protrusion 212 is shifted from the center of the subpixel 100 in the vertical direction of FIG. 24, but the present embodiment is not limited thereto. For example, in the present embodiment, the center of the protrusion 212 may be shifted from the center of the subpixel 100 in the horizontal direction of FIG. 24, or the center of the protrusion 212 may be shifted from the center of the subpixel 100 in both the vertical direction and the horizontal direction of FIG. 24.

In the present embodiment, as illustrated in FIG. 26, by shifting the center of the protrusion 212 from the center of the subpixel 100, the same effect as that obtained by main light beam control due to lens shift can be obtained. Specifically, in a case where the center of the protrusion 212 is set so as to overlap with the center of the subpixel 100, as indicated by a broken line in FIG. 26, light from the light emitting layer 204 is guided from the center of the subpixel 100 toward the front. As a result, a luminance at a position (angle of 0 degrees) on the front from the center of the subpixel 100 is the highest, and the luminance decreases as the distance from the center increases. Meanwhile, in a case where the center of the protrusion 212 is shifted from the center of the subpixel 100, as indicated by a solid line in FIG. 26, light from the light emitting layer 204 is guided to a position shifted from the center of the subpixel 100. As a result, the luminance increases at a position shifted from the center of the subpixel 100. As described above, by suitably shifting the center of the protrusion 212 from the center of the subpixel 100, a direction in which light from the light emitting layer 204 is guided can be suitably controlled.

Note that the present embodiment is not limited to the configuration illustrated in FIGS. 24, 25A, and 25B, and can be appropriately changed according to desired characteristics.

### <7.2 Modification>

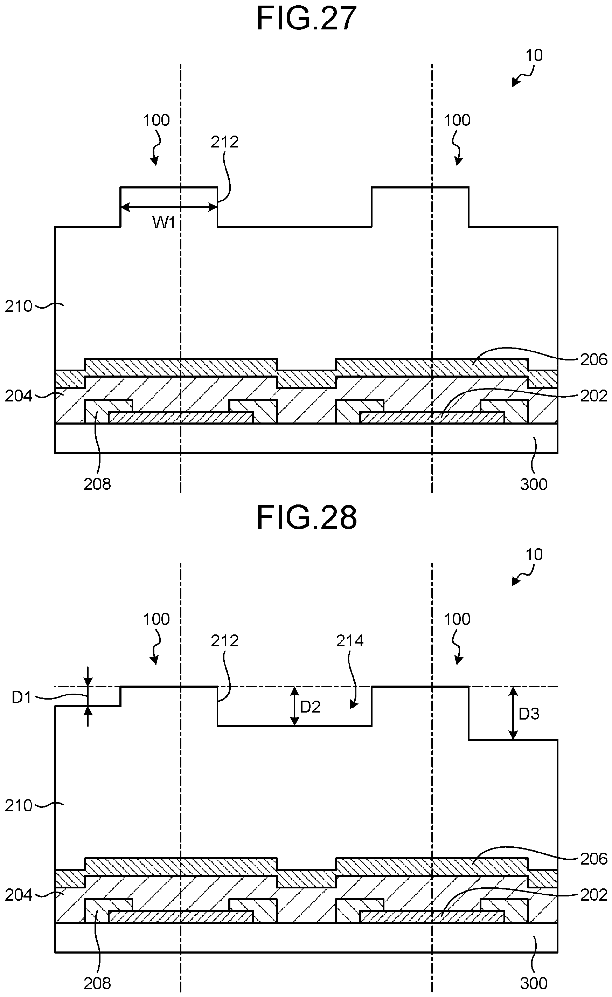

Next, a detailed configuration of a subpixel 100 in Modification of the present embodiment will be described with reference to FIGS. 27 and 28. FIG. 27 is a cross-sectional view for explaining an example of a cross-sectional configuration of a subpixel 100 according to Modification 1 of the present embodiment, and FIG. 28 is a cross-sectional view for explaining an example of a cross-sectional configuration of a subpixel 100 according to Modification 2 of the present embodiment. FIGS. 27 and 28 are cross-sectional views of the subpixel 100 cut along the thickness direction of the substrate 300. FIG. 28 is a cross-sectional view for explaining an example of a cross-sectional configuration of a subpixel 100 according to Modification 3 of the present embodiment, and specifically illustrates the light emitting device 10 in an upper part thereof, and illustrates cross-sectional configurations of the subpixel 100 at different positions in the light emitting device 10 in a lower part thereof. Note that the lower drawings are cross-sectional views of the subpixel 100 cut along the thickness direction of the substrate 300.

### (Modification 1)

FIG. 27 is a cross-sectional view of the subpixel 100 cut along line B-B' illustrated in FIG. 24, according to Modification of the present embodiment described above. In the present Modification, as illustrated in FIG. 27 which is a cross-sectional view of the subpixel 100 cut along line B-B', a width W1 of the protrusion 212 in the cross section cut along line A-A' is the same as a width W1 of the protrusion 212 in the cross section cut along line B-B' .

### (Modification 2)

In the present Modification, the depths of the two recesses 214 interposing the protrusion 212 above the subpixel 100 therebetween may be different from each other. For example, as illustrated in FIG. 28, the depths D1, D2, and D3 of the recesses 214 are deeper as it goes to the right in the drawing. As described above, in the present Modification, by changing the depth of the recess 214 depending on a position in the light emitting device 10, a direction in which the light of light emitting layer 204 is guided can be suitably controlled. Note that, in the present Modification, the depths D1, D2, and D3 of the recesses 214 are not limited to the configuration in which the depths are deeper as it goes to the right in the drawing, and for example, the depths D1, D2, and D3 of the recesses 214 may be deeper as it goes to the left in the drawing.

### (Modification 3)

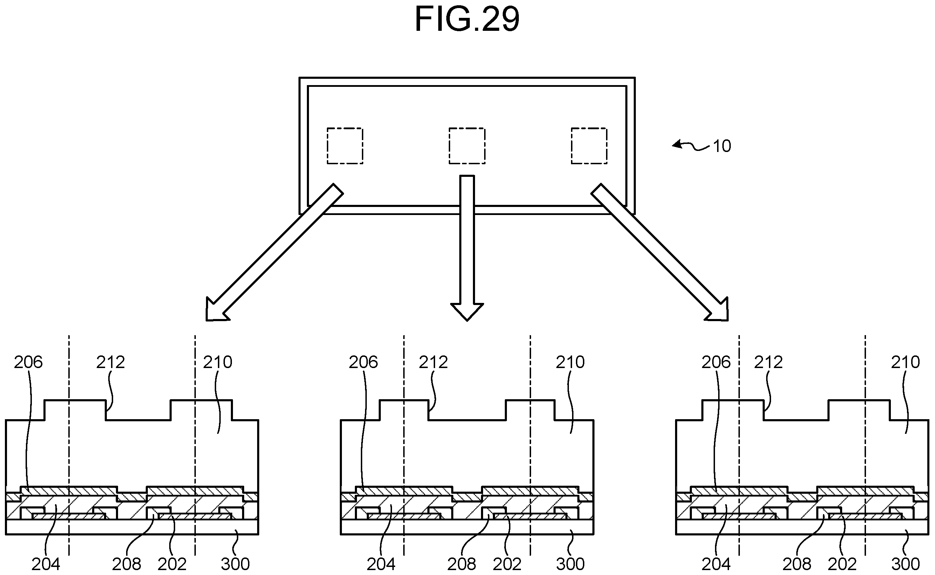

In the present Modification, as illustrated in FIG. 29, in a subpixel 100 located in a central portion of the light emitting device 10, as illustrated in the center in the lower part, the protrusion 212 is formed such that the center of the protrusion 212 overlaps with the center of the subpixel 100. Meanwhile, in a subpixel 100 located in a peripheral portion of the light emitting device 10, as illustrated on the right side and the left side in the lower part, the protrusion 212 is formed such that the center of the protrusion 212 is shifted from the center of the subpixel 100. That is, in the present Modification, a distance between the center of the protrusion 212 above the subpixel 100 and the center of the subpixel 100 may change depending on the position of the subpixel 100 in the light emitting device 10 (the position of the light emitting element on the substrate 300). With such a configuration, in the present Modification, light from the light emitting layer 204 of each subpixel 100 is guided toward the center of the light emitting device 10. As a result, according to the present Modification, it is possible to improve the upward light extraction efficiency of the light emitting device 10.

Note that, in the present Modification, the number of the recesses 214 formed on a surface of the protective film 210 between a subpixel 100 and a subpixel 100 adjacent thereto may change depending on the position of the subpixel 100 (the position of the light emitting element on the substrate 300) in the light emitting device 10. Furthermore, in the present Modification, the width and depth of the recess 214 adjacent to the protrusion 212 above the subpixel 100 may be changed depending on the position of the subpixel 100 (the position of the light emitting element on the substrate 300) in the light emitting device 10.

### <<8. Summary>>

As described above, in the embodiments of the present disclosure, light from the light emitting layer 204 is reflected by the side surface of the protrusion 212 (specifically, an interface between the protrusion 212 and the recess 214) and guided to an upper front of the subpixel 100 by the protective film 210 having the recess 214 and the protrusion 212. In addition, in the present embodiments, by forming the recess 214 such that a part of the recess 214 overlaps with a peripheral portion of the anode electrode 202 covered with the insulating film 208, most of light from the light emitting layer 204 can be suitably reflected by the side surface of the protrusion 212 and guided to the upper front of the subpixel 100. As a result, according to the present embodiments, it is possible to improve the upward light extraction efficiency of the light emitting device 10.

In addition, the light emitting device 10 according to any one of the embodiments of the present disclosure can be manufactured by using a method, a device, and conditions used for manufacturing a general semiconductor device. That is, the light emitting device 10 according to any one of the present embodiments can be manufactured using an existing method for manufacturing a semiconductor device.

Note that examples of the above-described method include a physical vapor deposition (PVD) method, a chemical vapor deposition (CVD) method, and an atomic layer deposition (ALD) method. Examples of the PVD method include a vacuum vapor deposition method, an electron beam (EB) vapor deposition method, various sputtering methods (a magnetron sputtering method, a radio frequency (RF)-direct current (DC) coupled bias sputtering method, an electron cyclotron resonance (ECR) sputtering method, a counter target sputtering method, a high frequency sputtering method, and the like), an ion plating method, a laser ablation method, a molecular beam epitaxy (MBE) method, and a laser transfer method. Examples of the CVD method include a plasma CVD method, a thermal CVD method, an organic metal (MO) CVD method, and a photo CVD method. Furthermore, examples of other methods include an electrolytic plating method, an electroless plating method, and a spin coating method; an immersion method; a cast method; a micro-contact printing method; a drop cast method; various printing methods such as a screen printing method, an inkjet printing method, an offset printing method, a gravure printing method, and a flexographic printing method; a stamping method; a spray method; and various coating methods such as an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit orifice coater method, and a calender coater method. Furthermore, examples of a patterning method include chemical etching such as shadow mask, laser transfer, or photolithography, and physical etching using ultraviolet rays, laser, or the like. In addition, examples of a planarization technique include a chemical mechanical polishing (CMP) method, a laser planarization method, and a reflow method.

### <<9. Modification>>

### <9.1 Modification 1>

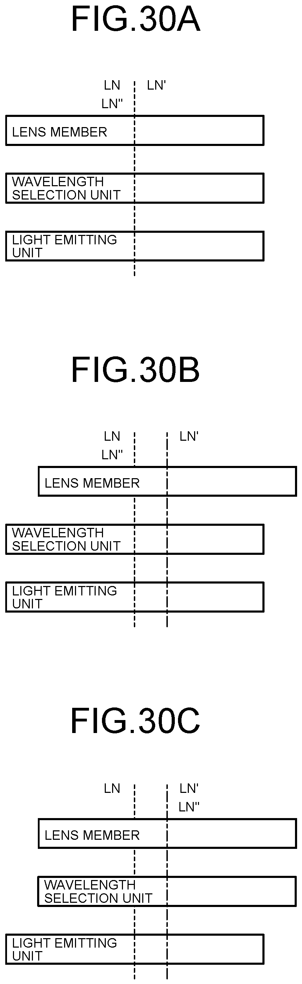

Next, as Modification of the embodiments of the present disclosure, Modification of a relationship among a normal line LN passing through a center of the subpixel 100, a normal line LN' passing through a center of a lens member (specifically, the on-chip lens 304), and a normal line LN" passing through a center of a wavelength selection unit (specifically, the color filter 302) will be described with reference to FIGS. 30A to 30G. FIGS. 30A to 30G are conceptual diagrams for explaining the relationship among the normal line LN passing through the center of the light emitting unit, the normal line LN' passing through the center of the lens member, and the normal line LN" passing through the center of the wavelength selection unit. Note that, in the following description, the center of the subpixel 100 is referred to as the center of a light emitting unit.

In the embodiments of the present disclosure, the size of the wavelength selection unit (for example, the color filter 302) may be appropriately changed depending on light emitted from the subpixel 100. Furthermore, in a case where a light absorption layer (black matrix layer) is formed between the wavelength selection units (for example, the color filters 302) of the subpixels 100 adjacent to each other, the size of the light absorption layer (black matrix layer) may be appropriately changed depending on light emitted from the subpixel 100. In addition, the size of the wavelength selection unit (for example, the color filter 302) may be appropriately changed depending on a distance (offset amount) d0 between a normal line passing through a center of the subpixel 100 and a normal line passing through a center of the color filter 302. The planar shape of the wavelength selection unit (for example, the color filter 302) may be the same as, similar to, or different from the planar shape of the lens member (for example, the on-chip lens 304).

For example, as illustrated in FIG. 30A, the normal line LN passing through the center of the light emitting unit, the normal line LN" passing through the center of the wavelength selection unit, and the normal line LN' passing through the center of the lens member may coincide with each other. In other words, a distance (offset amount) D0 between the normal line passing through the center of the light emitting unit and the normal line passing through the center of the lens member and a distance (offset amount) d0 between the normal line passing through the center of the light emitting unit and the normal line passing through the center of the wavelength selection unit can be equal to each other and can be set to zero.

In addition, as illustrated in FIG. 30B, a configuration may be adopted in which the normal line LN passing through the center of the light emitting unit coincide with the normal line LN" passing through the center of the wavelength selection unit, but the normal line LN passing through the center of the light emitting unit or the normal line LN" passing through the center of the wavelength selection unit does not coincide with the normal line LN' passing through the center of the lens member. In other words, D0 ≠ d0 = 0 may be satisfied.

In addition, as illustrated in FIG. 30C, a configuration may be adopted in which the normal line LN passing through the center of the light emitting unit does not coincide with the normal line LN" passing through the center of the wavelength selection unit or the normal line LN' passing through the center of the lens member, and the normal line LN" passing through the center of the wavelength selection unit coincides with the normal line LN' passing through the center of the lens member. In other words, D0 = d0 > 0 may be satisfied.

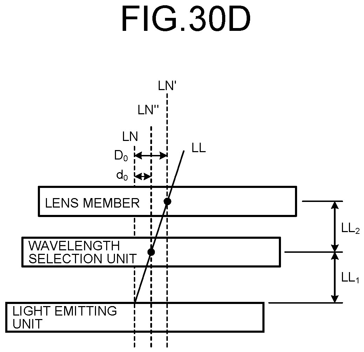

In addition, for example, as illustrated in FIG. 30D, a configuration can be adopted in which the normal line LN passing through the center of the light emitting unit does not coincide with the normal line LN" passing through the center of the wavelength selection unit or the normal line LN' passing through the center of the lens member, and the normal line LN' passing through the center of the lens member does not coincide with the normal line LN passing through the center of the light emitting unit or the normal line LN" passing through the center of the wavelength selection unit. Here, the center of the wavelength selection unit (indicated by a black square in FIG. 30D) is preferably located on a straight line LL connecting the center of the light emitting unit and the center of the lens member (indicated by a black circle in FIG. 30D). Specifically, when a distance from the center of the light emitting unit to the center of the wavelength selection unit in the thickness direction is represented by LL1, and a distance from the center of the wavelength selection unit to the center of the lens member in the thickness direction is represented by LL2, D0 > d0 > 0 is satisfied, and considering manufacturing variation, d0 : D0 = LL1: (LL1 + LL2) is preferably satisfied.

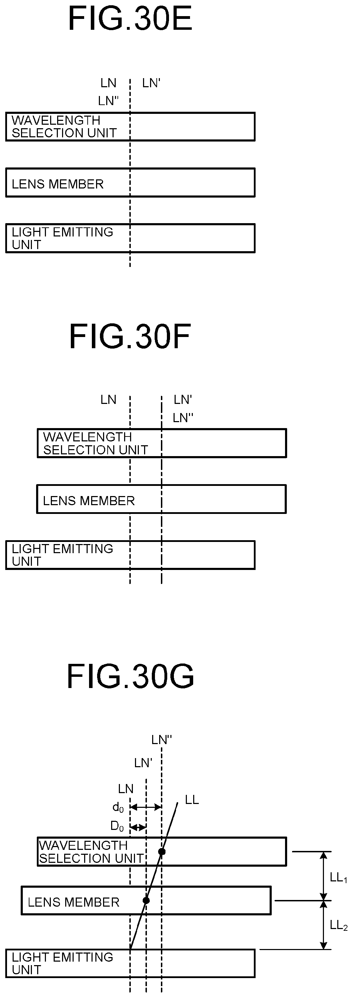

In addition, the laminating relationship between the wavelength distal end portion and the lens member may be interchanged. In such a case, for example, as illustrated in FIG. 30E, the normal line LN passing through the center of the light emitting unit, the normal line LN" passing through the center of the wavelength selection unit, and the normal line LN' passing through the center of the lens member may coincide with each other. In other words, D0 = d0 = 0 may be satisfied.

In addition, as illustrated in FIG. 30F, a configuration may be adopted in which the normal line LN passing through the center of the light emitting unit does not coincide with the normal line LN" passing through the center of the wavelength selection unit or the normal line LN' passing through the center of the lens member, and the normal line LN" passing through the center of the wavelength selection unit coincides with the normal line LN' passing through the center of the lens member. In other words, D0 = d0 > 0 may be satisfied.

Furthermore, as illustrated in FIG. 30G which is a conceptual diagram, a configuration can be adopted in which the normal line LN passing through the center of the light emitting unit does not coincide with the normal line LN" passing through the center of the wavelength selection unit or the normal line LN' passing through the center of the lens member, and the normal line LN' passing through the center of the lens member does not coincide with the normal line LN passing through the center of the light emitting unit or the normal line LN" passing through the center of the wavelength selection unit. Here, the center of the wavelength selection unit is preferably located on a straight line LL connecting the center of the light emitting unit and the center of the lens member. Specifically, when a distance from the center of the light emitting unit to the center of the wavelength selection unit (indicated by a black square in FIG. 30G) in the thickness direction is represented by LL1, and a distance from the center of the wavelength selection unit to the center of the lens member (indicated by a black circle in FIG. 30G) in the thickness direction is represented by LL2, d0 > D0 > 0 is satisfied, and considering manufacturing variation, D0 : d0 = LL2 : (LL1 + LL2) is preferably satisfied.

### <9.2 Modification 2>

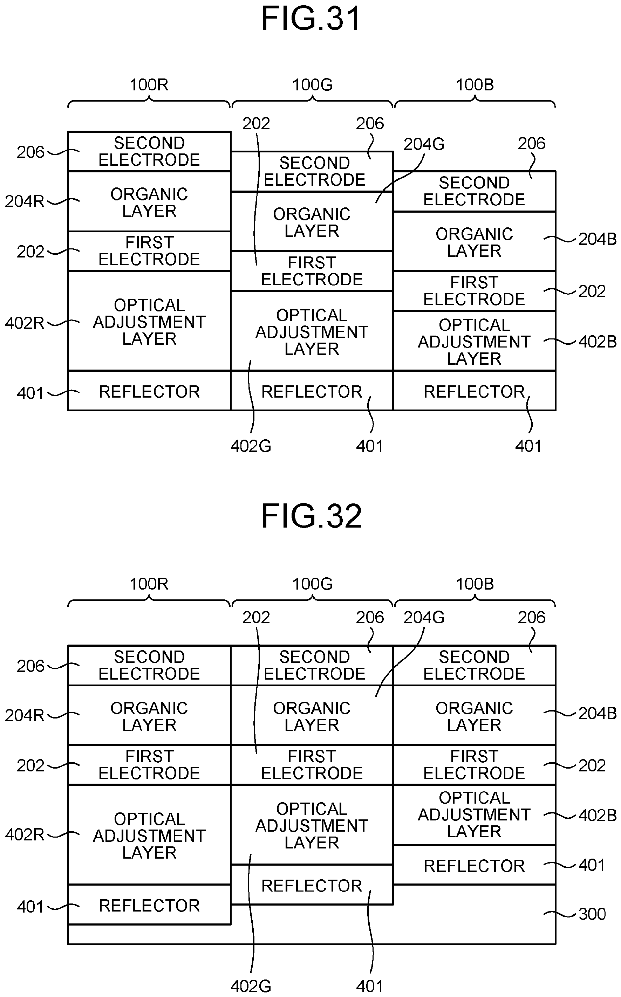

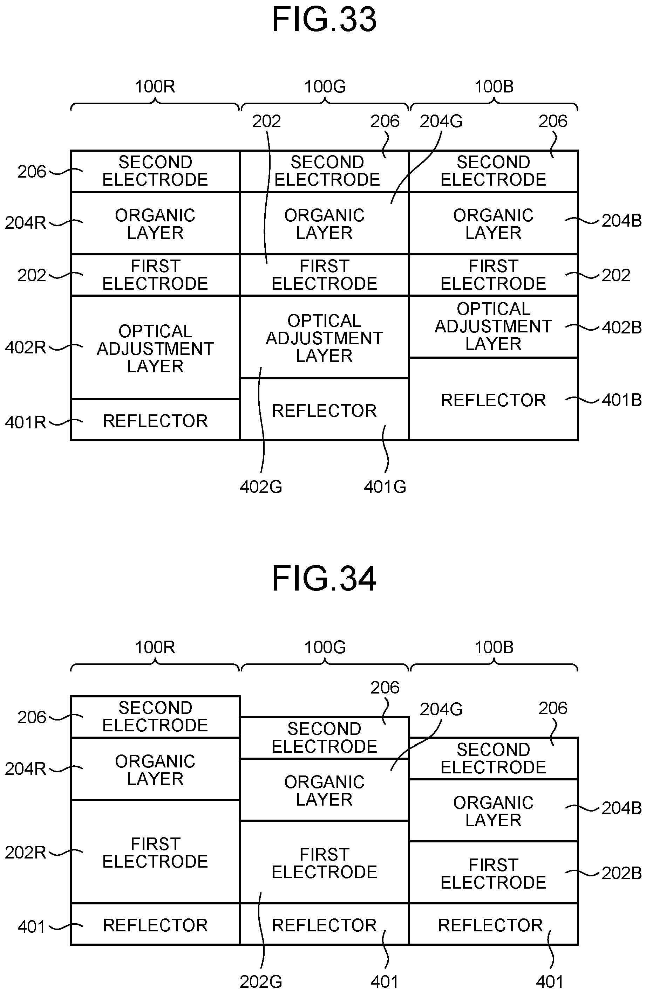

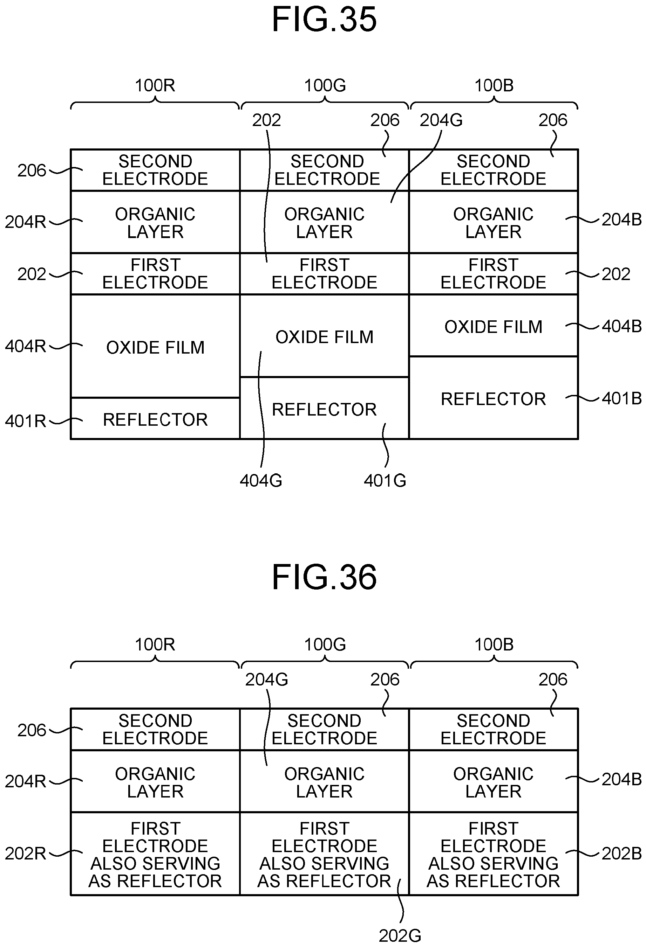

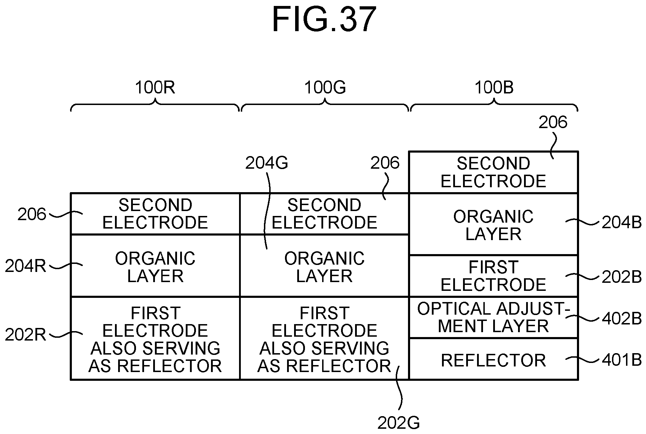

The subpixel 100 used in the light emitting device according to any one of the embodiments of the present disclosure described above can have a resonator structure that causes light generated in the light emitting layer 204 to resonate. Hereinafter, the resonator structure will be described with reference to FIGS. 31 to 37. FIG. 31 is a schematic cross-sectional view for explaining a first example of the resonator structure, FIG. 32 is a schematic cross-sectional view for explaining a second example of the resonator structure, and FIG. 33 is a schematic cross-sectional view for explaining a third example of the resonator structure. FIG. 34 is a schematic cross-sectional view for explaining a fourth example of the resonator structure, and FIG. 35 is a schematic cross-sectional view for explaining a fifth example of the resonator structure. FIG. 36 is a schematic cross-sectional view for explaining a sixth example of the resonator structure, and FIG. 37 is a schematic cross-sectional view for explaining a seventh example of the resonator structure.

### (Resonator structure: first example)

FIG. 31 is a schematic cross-sectional view for explaining a first example of the resonator structure. In the first example, the first electrode (for example, an anode electrode) 202 is formed with a common film thickness in the subpixels 100. The same applies to the second electrode (for example, a cathode electrode) 206.

As illustrated in FIG. 31, a reflector 401 is disposed below the first electrode 202 of the subpixel 100 with an optical adjustment layer 402 interposed therebetween. A resonator structure that resonates light generated by the organic layer (specifically, a light emitting layer) 204 is formed between the reflector 401 and the second electrode 206.

The reflector 401 is formed with a common film thickness in the subpixels 100. The film thickness of the optical adjustment layer 402 varies depending on a color to be displayed by the subpixel 100. Optical adjustment layers 402R, 402G, and 402B have different film thicknesses, whereby it is possible to set an optical distance at which optimum resonance occurs for a wavelength of light corresponding to a color to be displayed.

In the example illustrated in FIG. 31, arrangement is made such that upper surfaces of the reflectors 401 in subpixels 100R, 100G, and 100B are aligned. As described above, since the film thickness of the optical adjustment layer 402 varies depending on a color to be displayed by the subpixel 100, the position of an upper surface of the second electrode 206 varies depending on the types of the subpixels 100R, 100G, and 100B.

The reflector 401 can be formed using, for example, a metal such as aluminum (Al), silver (Ag), or copper (Cu), or an alloy containing these as a main component.

The optical adjustment layer 402 can be formed of an inorganic insulating material such as silicon nitride (SiNx), silicon oxide (SiOx), or silicon oxynitride (SiOxNy), or an organic resin material such as an acrylic resin or a polyimide-based resin. The optical adjustment layer 402 may be a single layer or a laminated film formed of these plurality of materials. In addition, the number of laminated layers may vary depending on the type of the subpixel 100.

For example, the first electrode 202 can be formed of a transparent conductive material such as indium tin oxide (ITO), indium zinc oxide (IZO), or zinc oxide (ZnO) .

The second electrode 206 preferably functions as a semi-transmission reflection film. The second electrode 206 can be formed using magnesium (Mg), silver (Ag), a magnesium-silver alloy (MgAg) containing these as a main component, an alloy containing an alkali metal or an alkaline earth metal, or the like.

### (Resonator structure: second example)

FIG. 32 is a schematic cross-sectional view for explaining a second example of the resonator structure. Also in the second example, each of the first electrode 202 and the second electrode 206 is formed with a common film thickness in the subpixels 100.

In addition, also in the second example, the reflector 401 is disposed below the first electrode 202 of the subpixel 100 with the optical adjustment layer 402 interposed therebetween. A resonator structure that resonates light generated by the organic layer 204 is formed between the reflector 401 and the second electrode 206. As in the first example, the reflector 401 is formed with a common film thickness in the subpixels 100, and the film thickness of the optical adjustment layer 402 varies depending on a color to be displayed by the subpixel 100.

In the first example illustrated in FIG. 31, arrangement is made such that upper surfaces of the reflectors 401 in the subpixels 100R, 100G, and 100B are aligned, and the positions of the upper surfaces of the second electrodes 206 vary depending on the types of the subpixels 100R, 100G, and 100B.

On the other hand, in the second example illustrated in FIG. 32, arrangement is made such that the upper surfaces of the second electrodes 206 are aligned in the subpixels 100R, 100G, and 100B. In order to align the upper surfaces of the second electrodes 206, arrangement is made such that an upper surface of the reflector 401 in each of the subpixels 100R, 100G, and 100B varies depending on the types of the subpixels 100R, 100G, and 100B. Therefore, lower surfaces of the reflectors 401 have a stepped shape depending on the types of the subpixels 100R, 100G, and 100B.

Materials and the like constituting the reflector 401, the optical adjustment layer 402, the first electrode 202, and the second electrode 206 are similar to the contents described in the first example, and thus description thereof is omitted.

### (Resonator structure: third example)

FIG. 33 is a schematic cross-sectional view for explaining a third example of the resonator structure. Also in the third example, each of the first electrode 202 and the second electrode 206 is formed with a common film thickness in the subpixels 100.

In addition, also in the third example, the reflector 401 is disposed below the first electrode 202 of the subpixel 100 with the optical adjustment layer 402 interposed therebetween. A resonator structure that resonates light generated by the organic layer 204 is formed between the reflector 401 and the second electrode 206. As in the first example and the second example, the film thickness of the optical adjustment layer 402 varies depending on a color to be displayed by the subpixel 100. As in the second example, arrangement is made such that the positions of the upper surfaces of the second electrodes 206 are aligned in the subpixels 100R, 100G, and 100B.

In the second example illustrated in FIG. 32, in order to align the upper surfaces of the second electrodes 206, the lower surfaces of the reflectors 401 have a stepped shape depending on the types of the subpixels 100R, 100G, and 100B.

On the other hand, in the third example illustrated in FIG. 33, the film thickness of the reflector 401 is set so as to vary depending on the types of the subpixels 100R, 100G, and 100B. More specifically, the film thicknesses are set such that lower surfaces of reflectors 401R, 401G, and 401B are aligned.

Materials and the like constituting the reflector 401, the optical adjustment layer 402, the first electrode 202, and the second electrode 206 are similar to the contents described in the first example, and thus description thereof is omitted.

### (Resonator structure: fourth example)

FIG. 34 is a schematic cross-sectional view for explaining a fourth example of the resonator structure.

In the first example illustrated in FIG. 31, each of the first electrode 202 and the second electrode 206 in the subpixels 100 is formed with a common film thickness. In addition, the reflector 401 is disposed below the first electrode 202 of the subpixel 100 with the optical adjustment layer 402 interposed therebetween.

On the other hand, in the fourth example illustrated in FIG. 34, the optical adjustment layer 402 is omitted, and the film thickness of the first electrode 202 is set so as to vary depending on the types of the subpixels 100R, 100G, and 100B.

The reflector 401 is formed with a common film thickness in the subpixels 100. The film thickness of the first electrode 202 varies depending on a color to be displayed by the subpixel 100. First electrodes 202R, 202G, and 202B have different film thicknesses, whereby it is possible to set an optical distance at which optimum resonance occurs for a wavelength of light corresponding to a color to be displayed.

Materials and the like constituting the reflector 401, the first electrode 202, and the second electrode 206 are similar to the contents described in the first example, and thus description thereof is omitted.

### (Resonator structure: fifth example)

FIG. 35 is a schematic cross-sectional view for explaining a fifth example of the resonator structure.

In the first example illustrated in FIG. 31, each of the first electrode 202 and the second electrode 206 is formed with a common film thickness in the subpixels 100. In addition, the reflector 401 is disposed below the first electrode 202 of the subpixel 100 with the optical adjustment layer 402 interposed therebetween.

On the other hand, in the fifth example illustrated in FIG. 35, the optical adjustment layer 402 is omitted, and instead of the optical adjustment layer 402, an oxide film 404 is formed on a surface of the reflector 401. The film thickness of the oxide film 404 is set so as to vary depending on the types of the subpixels 100R, 100G, and 100B.

The film thickness of the oxide film 404 varies depending on a color to be displayed by the subpixel 100. Oxide films 404R, 404G, and 404B have different film thicknesses, whereby it is possible to set an optical distance at which optimum resonance occurs for a wavelength of light corresponding to a color to be displayed.

The oxide film 404 is a film obtained by oxidizing a surface of the reflector 401, and is formed of, for example, aluminum oxide, tantalum oxide, titanium oxide, magnesium oxide, or zirconium oxide. The oxide film 404 functions as an insulating film for adjusting an optical path length (optical distance) between the reflector 401 and the second electrode 206.

The oxide film 404 that varies a film thickness depending on the types of the subpixels 100R, 100G, and 100B can be formed, for example, as follows.

First, an electrolytic solution is filled in a container, and a substrate on which the reflector 401 is formed is immersed in the electrolytic solution. In addition, an electrode is disposed so as to face the reflector 401.

Then, a positive voltage is applied to the reflector 401 on the basis of the electrode, and the reflector 401 is anodized. The film thickness of an oxide film due to the anodization is proportional to a voltage value with respect to the electrode. Therefore, anodization is performed in a state where voltages corresponding to the types of the subpixels 100R, 100G, and 100B are applied to the reflectors 401R, 401G, and 401B, respectively. As a result, the oxide films 404 having different film thicknesses can be collectively formed.

Materials and the like constituting the reflector 401, the first electrode 202, and the second electrode 206 are similar to the contents described in the first example, and thus description thereof is omitted.

### (Resonator structure: sixth example)

FIG. 36 is a schematic cross-sectional view for explaining a sixth example of the resonator structure. In the sixth example, the subpixel 100 is constituted by laminating the first electrode 202, the organic layer 204, and the second electrode 206. Note that, in the sixth example, the first electrode 202 is formed so as to function as both an electrode and a reflector. The first electrode (also serving as a reflector) 202 is formed of a material having an optical constant selected depending on the types of the subpixels 100R, 100G, and 100B. Phase shifts by the first electrodes (also serving as reflectors) 202 are different from each other, whereby it is possible to set an optical distance at which optimum resonance occurs for a wavelength of light corresponding to a color to be displayed.

The first electrode (also serving as a reflector) 202 can be formed of a single metal such as aluminum (Al), silver (Ag), gold (Au), or copper (Cu), or an alloy containing these as a main component. For example, the first electrode (also serving as a reflector) 202R of the subpixel 100R can be formed of copper (Cu), and the first electrode (also serving as a reflector) 202G of the subpixel 100G and the first electrode (also serving as a reflector) 202B of the subpixel 100B can be formed of aluminum.

Materials and the like constituting the second electrode 206 are similar to the contents described in the first example, and thus description thereof is omitted.

### (Resonator structure: seventh example)

FIG. 37 is a schematic cross-sectional view for explaining a seventh example of the resonator structure. In the seventh example, basically, the sixth example is applied to the subpixels 100R and 100G, and the first example is applied to the subpixel 100B. Also in this configuration, it is possible to set an optical distance at which optimum resonance occurs for a wavelength of light corresponding to a color to be displayed.

The first electrodes (also serving as reflectors) 202R and 202G used for the subpixels 100R and 100G can be formed of a single metal such as aluminum (Al), silver (Ag), gold (Au), or copper (Cu), or an alloy containing these as a main component.

Materials and the like constituting the reflector 401B, the optical adjustment layer 402B, and the first electrode 202B used for the subpixel 100B are similar to the contents described in the first example, and thus description thereof is omitted.

### <<10. Application Example>>

For example, the technique according to the present disclosure may be applied to display units and the like of various electronic apparatuses. Therefore, an example of an electronic apparatus to which the present technique can be applied will be described below.

### (Specific Example 1)

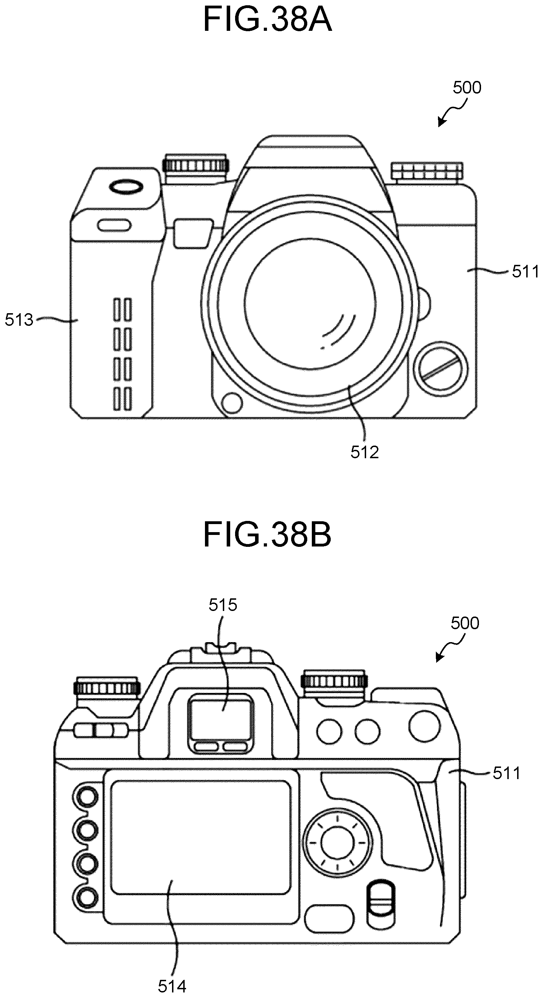

FIG. 38A is a front view illustrating an example of an external appearance of a digital still camera 500, and FIG. 38B is a rear view illustrating an example of the external appearance of the digital still camera 500. This digital still camera 500 is a lens interchangeable single lens reflex type camera, and includes an interchangeable imaging lens unit (interchangeable lens) 512 substantially at a center in front of a camera body 511, and a grip portion 513 to be gripped by a photographer on a front left side.

A monitor 514 is disposed at a position shifted to the left from a center of a back surface of the camera body 511. An electronic view finder (eyepiece window) 515 is disposed above the monitor 514. By looking into the electronic view finder 515, a photographer can visually recognize an optical image of a subject guided from the imaging lens unit 512 and determine a composition. As the monitor 514 and the electronic view finder 515, the light emitting device 10 according to any one of the embodiments of the present disclosure can be used.

### (Specific Example 2)

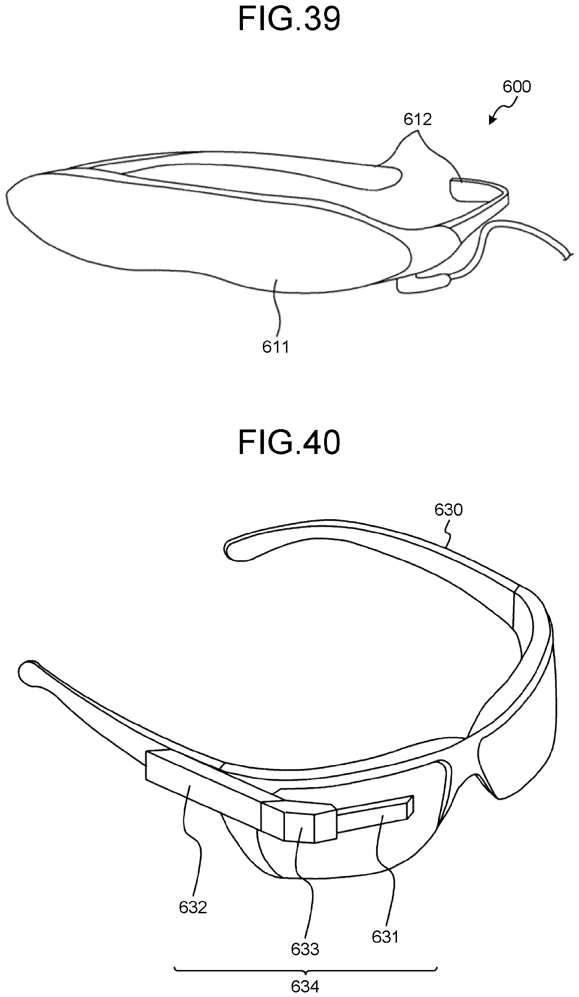

FIG. 39 is an external view of a head mounted display 600. The head mounted display 600 includes, for example, ear hooking portions 612 to be worn on a head of a user on both sides of a glass-shaped display unit 611. In this head mounted display 600, the light emitting device 10 according to any one of the embodiments of the present disclosure can be used as the display unit 611.

### (Specific Example 3)

FIG. 40 is an external view of a see-through head mounted display 634. The see-through head mounted display 634 includes a main body 632, an arm 633, and a lens barrel 631.

The main body 632 is connected to the arm 643 and glasses 630. Specifically, an end of the main body 632 in a long side direction is coupled to the arm 633, and one side of a side surface of the main body 632 is coupled to the glasses 630 via a connecting member. Note that the main body 632 may be directly worn on a head of a human body.

The main body 632 incorporates a control substrate for controlling an operation of the see-through head mounted display 634 and a display unit. The arm 633 connects the main body 632 and the lens barrel 631 to each other, and supports the lens barrel 631. Specifically, the arm 633 is coupled to an end of the main body 632 and an end of the lens barrel 631, and fixes the lens barrel 631. In addition, the arm 633 incorporates a signal line for communicating data related to an image provided from the main body 632 to the lens barrel 631.

The lens barrel 631 projects image light provided from the main body 632 via the arm 633 toward eyes of a user wearing the see-through head mounted display 634 through an eyepiece. In the see-through head mounted display 634, the light emitting device 10 according to ay one of the embodiments of the present disclosure can be used for the display unit of the main body 632.

### (Specific Example 4)

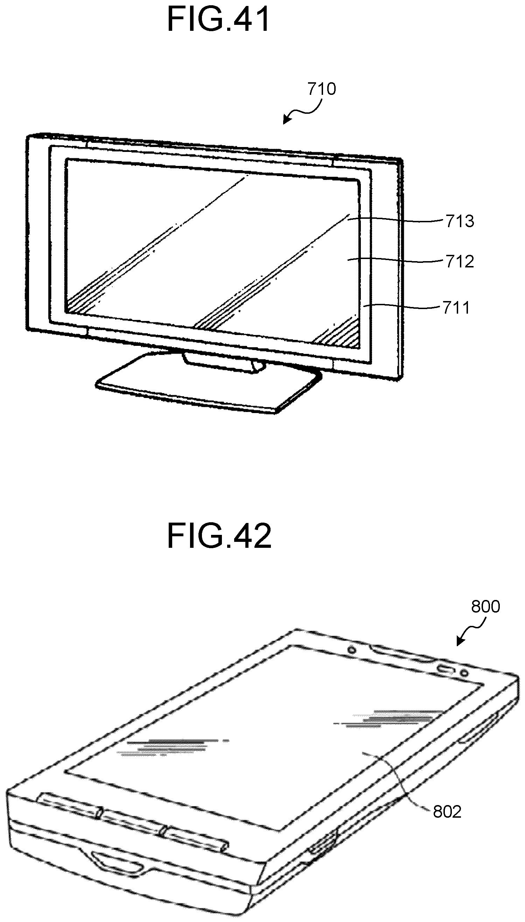

FIG. 41 illustrates an example of an external appearance of a television device 710. This television device 710 includes, for example, a video display screen unit 711 including a front panel 712 and a filter glass 713, and this video display screen unit 711 is constituted by the light emitting device 10 according to any one of the embodiments of the present disclosure.

### (Specific Example 5)

FIG. 42 illustrates an example of an external appearance of a smartphone 800. The smartphone 800 includes a display unit 802 that displays various types of information, an operation unit constituted by a button or the like that receives an operation input by a user, and the like. The display unit 802 can be the light emitting device 10 according to any one of the present embodiments.

### (Specific Example 6)

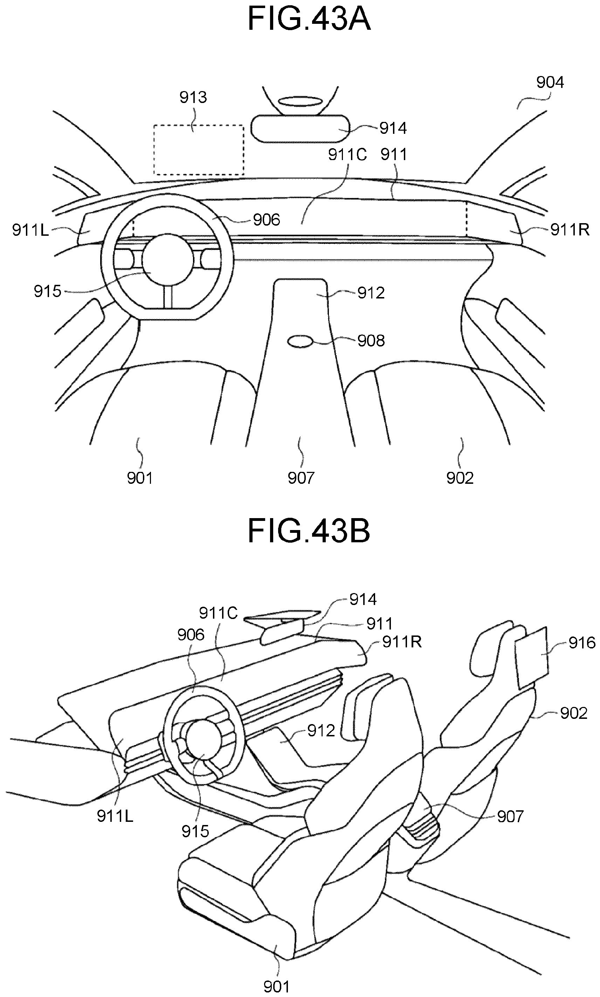

FIGS. 43A and 43B are each a view illustrating an internal configuration of an automobile including the light emitting device 10 according to any one of the embodiments of the present disclosure as a display device. Specifically, FIG. 43A is a view illustrating an internal state of an automobile from a rear to a front of the automobile, and FIG. 43B is a view illustrating an internal state of the automobile from an oblique rear to an oblique front of the automobile.

The automobile illustrated in FIGS. 43A and 43B includes a center display 911, a console display 912, a head-up display 913, a digital rear mirror 914, a steering wheel display 915, and a rear entertainment display 916. The light emitting device 10 according to any one of the embodiments of the present disclosure can be applied to some or all of these displays.

The center display 911 is disposed at a position facing a driver's seat 901 and an assistant driver's seat 902 above the center console 907. FIGS. 43A and 43B illustrate an example of the center display 911 having a horizontally long shape extending from the driver's seat 901 side to the assistant driver's seat 902 side, but the screen size of the center display 911 can be any size and a place where the center display 911 is disposed can be any position. The center display 911 can display information detected by various sensors (not illustrated). As a specific example, the center display 911 can display a captured image captured by an image sensor, a distance image to an obstacle in front of or on a side of the vehicle, measured by a time of flight (ToF) sensor, a passenger's body temperature detected by an infrared sensor, and the like. The center display 911 can be used in order to display, for example, at least one of safety-related information, operation-related information, a life log, health-related information, authentication/identification-related information, and entertainment-related information.

The safety-related information is information such as doze detection, looking-away detection, detection of mischief of a child in the automobile, presence or absence of wearing of a seat belt, or detection of leaving of an occupant, and is, for example, information detected by a sensor (not illustrated) disposed so as to overlap with a back side of the center display 1911. The operation-related information detects a gesture related to an operation of an occupant using a sensor. The detected gesture may include operations of various devices in the automobile. For example, operations of air conditioning equipment, a navigation device, an audio/visual (AV) device, a lighting device, and the like are detected. The life log includes life logs of all the occupants. For example, the life log includes an action record of each occupant in the automobile. By acquiring and storing the life log, it is possible to confirm a state of an occupant at the time of an accident. The health-related information detects a body temperature of an occupant using a temperature sensor, and estimates a health state of the occupant on the basis of the detected body temperature. Alternatively, a face of an occupant may be imaged using an image sensor, and a health state of the occupant may be estimated from the imaged facial expression. Furthermore, a conversation may be made with an occupant in an automatic voice, and a health condition of the occupant may be estimated on the basis of an answer content of the occupant. The authentication/identification-related information includes a keyless entry function of performing face authentication using a sensor, an automatic adjustment function of a sheet height and a position in face identification, and the like. The entertainment-related information includes a function of detecting operation information of an AV device by an occupant using a sensor, a function of recognizing a face of the occupant by the sensor and providing a content suitable for the occupant by the AV device, and the like.

The console display 912 can be used, for example, for displaying life log information. The console display 912 is disposed near a shift lever 908 of the center console 907 between the driver's seat 901 and the assistant driver's seat 902. The console display 912 can also display information detected by various sensors (not illustrated). In addition, the console display 912 may display an image of a periphery of the vehicle imaged by an image sensor, or may display a distance image to an obstacle in the periphery of the vehicle.

The head-up display 913 is virtually displayed behind a windshield 904 in front of the driver's seat 901. The head-up display 913 can be used in order to display, for example, at least one of safety-related information, operation-related information, a life log, health-related information, authentication/identification-related information, and entertainment-related information. Since the head-up display 913 is virtually disposed in front of the driver's seat 901 in many cases, the head-up display 913 is suitable for displaying information directly related to an operation of the automobile, such as a speed of the automobile or a remaining amount of fuel (battery).

The digital rear mirror 914 can display not only a rear of the vehicle but also a state of an occupant in a back seat, and therefore can be used, for example, for displaying life log information by disposing a sensor (not illustrated) so as to overlap with a back side of the digital rear mirror 914.

The steering wheel display 915 is disposed near a center of a steering wheel 906 of the automobile. The steering wheel display 915 can be used in order to display, for example, at least one of safety-related information, operation-related information, a life log, health-related information, authentication/identification-related information, and entertainment-related information. In particular, the steering wheel display 915 is close to a driver's hand, and therefore is suitable for displaying life log information such as a body temperature of the driver, or displaying information related to an operation of an AV device, air conditioning equipment, or the like.

The rear entertainment display 916 is attached to a back side of the driver's seat 901 or the assistant driver's seat 902, and is to be viewed by an occupant in a back seat. The rear entertainment display 916 can be used in order to display, for example, at least one of safety-related information, operation-related information, a life log, health-related information, authentication/identification-related information, and entertainment-related information. In particular, the rear entertainment display 916 is in front of an occupant in a back seat, and therefore displays information related to the occupant in the back seat. For example, the rear entertainment display 916 may display information related to an operation of an AV device or air conditioning equipment, or may display a result of measuring a body temperature or the like of the occupant in the back seat by a temperature sensor (not illustrated).

### <<11. Supplement>>

Hitherto, the preferred embodiments of the present disclosure have been described in detail with reference to the attached drawings. However, the technical scope of the present disclosure is not limited to such an example. It is obvious that a person having ordinary knowledge in the technical field of the present disclosure can conceive various change examples or modification examples within the scope of the technical idea described in the claims, and it is naturally understood that these also belong to the technical scope of the present disclosure.

In addition, the effects described in the present specification are merely illustrative or exemplary, and are not restrictive. That is, the technique according to the present disclosure can exhibit other effects obvious to those skilled in the art from the description of the present specification together with or instead of the above effects.

Note that the present technique can also have the following configurations.
(1) A light emitting device comprising a plurality of light emitting elements arranged on a substrate, wherein
   each of the light emitting elements includes:
   a first electrode disposed on the substrate;
   a pixel separation film covering a peripheral portion of the first electrode;
   a light emitting layer that is laminated on the first electrode and emits light;
   a second electrode that is laminated on the light emitting layer and transmits light from the light emitting layer; and
   a protective film that is laminated on the second electrode and transmits light from the light emitting layer,
   the protective films of the adjacent light emitting elements are formed so as to be continuous,
   a surface of the protective film located on a side opposite to the second electrode has a plurality of protrusions and recesses,
   at least one of the plurality of protrusions is formed above the light emitting element, and
   a part of the recess adjacent to the protrusion formed above the light emitting element overlaps with the peripheral portion of the first electrode covered with the pixel separation film when viewed from above the substrate.
(2) The light emitting device according to (1), wherein the protrusion formed above the light emitting element is formed such that a center of the protrusion overlaps with a center of the light emitting element.
(3) The light emitting device according to (1), wherein a distance between a center of the protrusion formed above the light emitting element and a center of the light emitting element changes depending on a position of the light emitting element on the substrate.
(4) The light emitting device according to any one of (1) to (3), wherein a width of the recess has a length of a half or more of a wavelength of light emitted from the light emitting layer.
(5) The light emitting device according to any one of (1) to (4), wherein each of the light emitting elements further includes a planarizing film formed in the recess.
(6) The light emitting device according to (5), wherein a difference in refractive index between the planarizing film and the protective film is 0.1 or more.
(7) The light emitting device according to (5) or (6), in which the planarizing film is formed on the protrusion.
(8) The light emitting device according to (7), in which a film thickness of the planarizing film on the protrusion is a half or less of a wavelength of light emitted from the light emitting layer.
(9) The light emitting device according to any one of (5) to (8), in which each of the light emitting elements includes a color filter disposed above the planarizing film for each of the light emitting elements.
(10) The light emitting device according to any one of (5) to (9), in which each of the light emitting elements includes an on-chip lens disposed above the planarizing film for each of the light emitting elements.
(11) The light emitting device according to (5) or (6),
   wherein each of the light emitting elements includes a color filter disposed on the protrusion so as to be in contact with the protrusion for each of the light emitting elements.
(12) The light emitting device according to (11), wherein a surface of the color filter on the protrusion side has unevenness so as to be engaged with the protrusion.
(13) The light emitting device according to (11) or (12), in which a difference in refractive index between the color filter and the protective film is 0.1 or less.
(14) The light emitting device according to any one of (1) to (13), wherein a depth of the recess is 0.1 µm or more.
(15) The light emitting device according to any one of (1) to (14), wherein an angle of a side surface of the recess with respect to a bottom surface of the recess is 70 degrees or more and 110 degrees or less.
(16) The light emitting device according to any one of (1) to (15), wherein
   the protective film includes an etching stopper layer, and
   the protrusion is formed on the etching stopper layer.
(17) The light emitting device according to any one of (1) to (16), in which the light emitting element has a polygonal shape when viewed from above the substrate.
(18) The light emitting device according to any one of (1) to (17), in which the plurality of light emitting elements are arranged in a square arrangement, a stripe arrangement, or a delta arrangement on the substrate.
(19) The light emitting device according to any one of (1) to (18), in which the light emitting layers of the adjacent light emitting elements are formed so as to be continuous.
(20) The light emitting device according to any one of (1) to (18), wherein the light emitting layer of the light emitting element has a connection portion connecting the light emitting layers of the adjacent light emitting elements to each other, and is divided into the light emitting elements at a portion other than the connection portion.
(21) The light emitting device according to any one of (1) to (8), wherein the light emitting layer of the light emitting element is divided into the light emitting elements.
(22) The light emitting device according to (21), wherein the second electrodes of the adjacent light emitting elements are electrically connected to each other via a third electrode penetrating the protective film.
(23) The light emitting device according to (21) or (22), in which the light emitting layers of the light emitting elements emit light having wavelengths different from each other.
(24) The light emitting device according to (23), wherein the number of the recesses formed on a surface of the protective film between the adjacent light emitting elements changes depending on a wavelength of light emitted from the light emitting layer.
(25) The light emitting device according to (23) or (24), wherein a width or a depth of the recess formed on a surface of the protective film changes depending on a wavelength of light emitted from the light emitting layer.
(26) The light emitting device according to any one of (1) to (23), in which one of the recesses is formed on the surface of the protective film between the adjacent light emitting elements.
(27) The light emitting device according to any one of (1) to (23), wherein the plurality of recesses is formed on the surface of the protective film between the adjacent light emitting elements.
(28) The light emitting device according to (27), wherein the number of the recesses formed on the surface of the protective film between the adjacent light emitting elements changes depending on a position of the light emitting element on the substrate.
(29) The light emitting device according to (27) or (28), wherein a width or a depth of the recess formed on the surface of the protective film changes depending on a position of the light emitting element on the substrate.
(30) An electronic apparatus comprising a light emitting device including a plurality of light emitting elements arranged on a substrate, wherein
   each of the light emitting elements includes:
   a first electrode disposed on the substrate;
   a pixel separation film covering a peripheral portion of the first electrode;
   a light emitting layer that is laminated on the first electrode and emits light;
   a second electrode that is laminated on the light emitting layer and transmits light from the light emitting layer; and
   a protective film that is laminated on the second electrode and transmits light from the light emitting layer,
   the protective films of the adjacent light emitting elements are formed so as to be continuous,
   a surface of the protective film located on a side opposite to the second electrode has a plurality of protrusions and recesses,
   at least one of the plurality of protrusions is formed above the light emitting element, and
   a part of the recess adjacent to the protrusion formed above the light emitting element overlaps with the peripheral portion of the first electrode covered with the pixel separation film when viewed from above the substrate.

### Reference Signs List

10, 10a LIGHT EMITTING DEVICE
11 HORIZONTAL DRIVE CIRCUIT
12 VERTICAL DRIVE CIRCUIT
20, 20a PIXEL
100, 100a, 100B, 100G, 100R SUBPIXEL
202, 202G, 202R ANODE ELECTRODE
204, 204B, 204G, 204R LIGHT EMITTING LAYER
204a CONNECTION PORTION
206 CATHODE ELECTRODE
208 INSULATING FILM
210 PROTECTIVE FILM
212 PROTRUSION
214 RECESS
220 PLANARIZING FILM
230 ETCHING STOPPER FILM
300 SUBSTRATE
302 COLOR FILTER
304 ON-CHIP LENS
310 ELECTRODE
320 CONTACT HOLE
400 MASK
401, 401B, 401G, 401R REFLECTOR
402, 402B, 402G, 402R OPTICAL ADJUSTMENT LAYER
404 OXIDE FILM
500 DIGITAL STILL CAMERA
511 CAMERA BODY
512 IMAGING LENS UNIT
513 GRIP PORTION
514 MONITOR
515 ELECTRONIC VIEW FINDER
600 HEAD MOUNTED DISPLAY
611, 802 DISPLAY UNIT
612 EAR HOOKING PORTION
630 GLASSES
631 LENS BARREL
632 MAIN BODY
633 ARM
634 SEE-THROUGH HEAD MOUNTED DISPLAY
710 TELEVISION DEVICE
711 VIDEO DISPLAY SCREEN UNIT
712 FRONT PANEL
713 FILTER GLASS
800 SMARTPHONE
901 DRIVER'S SEAT
902 ASSISTANT DRIVER'S SEAT
904 WINDSHIELD
906 STEERING WHEEL
907 CENTER CONSOLE
908 SHIFT LEVER
911 CENTER DISPLAY
912 CONSOLE DISPLAY
913 HEAD-UP DISPLAY
914 DIGITAL REAR MIRROR
915 STEERING WHEEL DISPLAY
916 REAR ENTERTAINMENT DISPLAY
C1 CAPACITOR
C_{EL} CAPACITANCE
DTLn SIGNAL LINE
ELP LIGHT EMITTING ELEMENT
PS1m FEEDER LINE
PS2 COMMON FEEDER LINE
SCLm SCANNING LINE
TRw WRITE TRANSISTOR
TR_{D} DRIVE TRANSISTOR

## Claims

1. A light emitting device comprising a plurality of light emitting elements arranged on a substrate, wherein
each of the light emitting elements includes:
a first electrode disposed on the substrate;
a pixel separation film covering a peripheral portion of the first electrode;
a light emitting layer that is laminated on the first electrode and emits light;
a second electrode that is laminated on the light emitting layer and transmits light from the light emitting layer; and
a protective film that is laminated on the second electrode and transmits light from the light emitting layer,
the protective films of the adjacent light emitting elements are formed so as to be continuous,
a surface of the protective film located on a side opposite to the second electrode has a plurality of protrusions and recesses,
at least one of the plurality of protrusions is formed above the light emitting element, and
a part of the recess adjacent to the protrusion formed above the light emitting element overlaps with the peripheral portion of the first electrode covered with the pixel separation film when viewed from above the substrate.

2. The light emitting device according to claim 1, wherein the protrusion formed above the light emitting element is formed such that a center of the protrusion overlaps with a center of the light emitting element.

3. The light emitting device according to claim 1, wherein a distance between a center of the protrusion formed above the light emitting element and a center of the light emitting element changes depending on a position of the light emitting element on the substrate.

4. The light emitting device according to claim 1, wherein a width of the recess has a length of a half or more of a wavelength of light emitted from the light emitting layer.

5. The light emitting device according to claim 1, wherein each of the light emitting elements further includes a planarizing film formed in the recess.

6. The light emitting device according to claim 5, wherein a difference in refractive index between the planarizing film and the protective film is 0.1 or more.

7. The light emitting device according to claim 5, wherein each of the light emitting elements includes a color filter disposed on the protrusion so as to be in contact with the protrusion for each of the light emitting elements.

8. The light emitting device according to claim 7, wherein a surface of the color filter on the protrusion side has unevenness so as to be engaged with the protrusion.

9. The light emitting device according to claim 1, wherein a depth of the recess is 0.1 µm or more.

10. The light emitting device according to claim 1, wherein an angle of a side surface of the recess with respect to a bottom surface of the recess is 70 degrees or more and 110 degrees or less.

11. The light emitting device according to claim 1, wherein
the protective film includes an etching stopper layer, and
the protrusion is formed on the etching stopper layer.

12. The light emitting device according to claim 1, wherein the light emitting layer of the light emitting element has a connection portion connecting the light emitting layers of the adjacent light emitting elements to each other, and is divided into the light emitting elements at a portion other than the connection portion.

13. The light emitting device according to claim 1, wherein the light emitting layer of the light emitting element is divided into the light emitting elements.

14. The light emitting device according to claim 13, wherein the second electrodes of the adjacent light emitting elements are electrically connected to each other via a third electrode penetrating the protective film.

15. The light emitting device according to claim 13, wherein the number of the recesses formed on a surface of the protective film between the adjacent light emitting elements changes depending on a wavelength of light emitted from the light emitting layer.

16. The light emitting device according to claim 13, wherein a width or a depth of the recess formed on a surface of the protective film changes depending on a wavelength of light emitted from the light emitting layer.

17. The light emitting device according to claim 1, wherein the plurality of recesses is formed on the surface of the protective film between the adjacent light emitting elements.

18. The light emitting device according to claim 17, wherein the number of the recesses formed on the surface of the protective film between the adjacent light emitting elements changes depending on a position of the light emitting element on the substrate.

19. The light emitting device according to claim 17, wherein a width or a depth of the recess formed on the surface of the protective film changes depending on a position of the light emitting element on the substrate.

20. An electronic apparatus comprising a light emitting device including a plurality of light emitting elements arranged on a substrate, wherein
each of the light emitting elements includes:
a first electrode disposed on the substrate;
a pixel separation film covering a peripheral portion of the first electrode;
a light emitting layer that is laminated on the first electrode and emits light;
a second electrode that is laminated on the light emitting layer and transmits light from the light emitting layer; and
a protective film that is laminated on the second electrode and transmits light from the light emitting layer,
the protective films of the adjacent light emitting elements are formed so as to be continuous,
a surface of the protective film located on a side opposite to the second electrode has a plurality of protrusions and recesses,
at least one of the plurality of protrusions is formed above the light emitting element, and
a part of the recess adjacent to the protrusion formed above the light emitting element overlaps with the peripheral portion of the first electrode covered with the pixel separation film when viewed from above the substrate.
